# EUROPEAN PATENT APPLICATION

(11) **EP 2 128 706 A1**
(43) Date of publication of application: **02.12.2009**
(21) Application number: 08721759.2
(22) Date of filing: 11.03.2008
(51) Int. Cl.: G03F 7/40, H01L 21/027

(54) **RESIST PATTERN FORMATION METHOD, AND RESIN COMPOSITION CAPABLE OF INSOLUBILIZING RESIST PATTERN**

(30) Priority: 16.03.2007 JP 2007069238; 25.09.2007 JP 2007246843
(71) Applicant: JSR Corporation, Tokyo 104-8410 (JP)
(72) Inventor: NAKAMURA, Atsushi, Tokyo 104-8410 (JP); NAGAI, Tomoki, Tokyo 104-8410 (JP); ABE, Takayoshi, Tokyo 104-8410 (JP); KAKIZAWA, Tomohiro, Tokyo 104-8410 (JP)
(74) Representative: TBK-Patent
(86) International application number: PCT/JP2008/054343
(87) International publication number: WO 2008/114644

(57) **Abstract**

A resist pattern formation method includes (1) a step of forming a first resist pattern which includes forming a first resist layer on a substrate, selectively exposing the first resist layer to radiation through a mask, and developing the exposed first resist layer, (2) a step of insolubilizing the first resist pattern by coating the first resist pattern with a resist pattern insolubilizing resin composition, baking or curing with UV, and developing the resist pattern insolubilizing resin composition, (3) a step of forming a second resist layer on the insolubilized resist pattern and selectively exposing the second resist layer to radiation through a mask, and (4) a step of developing the exposed second resist layer to form a second resist pattern.

## Description

### TECHNICAL FIELD

The present invention relates to a resin composition capable of insolubilizing a resist pattern and a method for forming a fine resist pattern using the resin composition.

### BACKGROUND ART

In the field of microfabrication represented by the manufacture of integrated circuit devices, lithographic technology enabling microfabrication with a line width of 0.10 µm or less has been demanded in recent years in order to increase the degree of integration. However, microfabrication in a subquarter micron level is said to be very difficult using near ultraviolet rays such as i-lines which are generally used as radiation in a common lithography process. Therefore, in order to perform microfabrication with a line width of 0.10 µm or less, use of radiation with a shorter wavelength has been studied. As examples of such short wavelength radiation, bright line spectrum of a mercury lamp, deep ultraviolet rays represented by excimer lasers, X rays, electron beams, and the like can be given. Particular attention has been given to a KrF excimer laser (wavelength: 248 nm) and an ArF excimer laser (wavelength: 193 nm).

As a resist suitable for being irradiated with such an excimer laser, many chemically amplified resists utilizing the chemical amplification effect of a component having an acid-dissociable functional group (hereinafter referred to from time to time as "an acid generator") and exposure to radiation (hereinafter referred to from time to time as "exposure") have been proposed. As a chemically amplified resist, a resist containing a resin having a t-butyl ester group of carboxylic acid or a t-butyl carbonate group of phenol and an acid generator has been proposed (see Patent Document 1, for example). The t-butyl ester group or t-butyl carbonate group in the resin dissociates by the action of an acid generated upon exposure, whereby the resist is provided with an acidic group such as a carboxylic group or a phenolic hydroxyl group. As a result, the exposed areas of the resist film become readily soluble in an alkaline developer. The resist utilizes this phenomenon.

A capability of forming more minute patterns (a minute resist pattern with a line width of about 45 nm, for example) will be required for the lithographic process in the future. Reducing the wavelength of a light source of an exposure instrument and increasing the numerical aperture (NA) of a lens could be a means for forming a pattern with a line width of below 45 nm. However, an expensive exposure machine is necessary for reducing the wavelength of a light source. In addition, due to a trade-off relationship between the resolution and the depth of focus, increasing the numerical aperture (NA) of a lens involves a problem of decreasing the depth of focus even if resolution is increased.

Recently, a liquid immersion lithographic method has been reported as a lithographic technique enabling solution of such a problem (see Patent Document 2, for example). In the liquid immersion lithographic process, a layer of a liquid high refractive index medium (liquid for liquid immersion lithography) such as pure water or a fluorine-containing inert liquid is caused to be present between the lens and the resist film on a substrate, at least on the surface of the resist film. According to this method, an inert gas atmosphere in the light-path space, such as air and nitrogen, is replaced by a liquid with a larger refractive index (n), for example, pure water, whereby resolution can be increased without a decrease in the focal depth by using a light source with a given wavelength to the same degree as in the case in which a light source with a shorter wavelength is used or the case in which a higher NA lens is used. Since a resist pattern with a higher resolution excelling in focal depth can be formed at a low cost using a lens mounted in existing apparatuses by using the liquid immersion lithographic method, the method has received a great deal of attention and is currently being put into practice.

Although downsizing of the line width of the above exposure technology is said to be up to 45 nmhp at most, the technological development is advancing toward a 32 nmhp generation requiring further minute fabrication. More recently, in an effort to respond to such device complication and high density requirement a double patterning or double exposure technology of patterning 32 nm LS by producing a rough line pattern or an isolated trench pattern and superposing these patterns displacing one pattern from the other by half a pitch has been proposed (see Non-patent Document 1, for example).

In one proposed example, after forming a 1:3 pitch 32 nm line and after etching, another 1:3 pitch 32 nm line is formed in a position displaced from the first position by half a pitch, again followed by etching. As a result, a 1:1 pitch 32 nm line can be ultimately formed. Although several processes of these types have been proposed, none has disclosed a specific method, material, and the like which can be put into practice.

Patent Document 1: JP-A-5-232704
Patent Document 2: JP-A-10-303114
Non-patent Document 1: SPIE 2006 Vol. 6153 61531K

### DISCLOSURE OF THE INVENTION

The present invention has been achieved in view of these problems in general technologies and has an object of providing a resist pattern formation method which can form a fine resist pattern easily and efficiently, and a resin composition capable of insolubilizing the resist pattern which is used in the resist pattern formation method.

As a result of extensive studies in order to achieve the above object, the inventors of the present invention have found that the above object can be achieved by a method of forming a resist pattern which is insoluble in a developer and the like using a specific resin composition and further forming another resist pattern on the insolubilized resist pattern. This finding has led to the completion of the present invention.

Specifically, the following resist pattern formation method and resist pattern insolubilizing resin composition are provided according to the present invention.

[1] A resist pattern formation method comprising (1) a step of forming a first resist pattern which comprises forming a first resist layer on a substrate using a first positive-tone radiation-sensitive resin composition, selectively exposing the first resist layer to radiation through a mask, and developing the exposed first resist layer, (2) a step of insolubilizing the first resist pattern in a developer and a second positive-tone radiation-sensitive resin composition by coating the first resist pattern with a resist pattern insolubilizing resin composition which comprises a resin having a hydroxyl group and an alcohol solvent, baking the resist pattern insolubilizing resin composition or curing the resist pattern insolubilizing resin composition with UV, and developing the resist pattern insolubilizing resin composition, (3) a step of forming a second resist layer on the insolubilized resist pattern using the second positive-tone radiation-sensitive resin composition and selectively exposing the second resist layer to radiation through a mask, and (4) a step of developing the exposed second resist layer to form a second resist pattern.

[2] The resist pattern formation method according to [1], wherein the insolubilized resist pattern and the second resist pattern are respectively line-and-space patterns each having line parts and space parts, and the line parts of the second resist pattern are formed on the space parts of the insolubilized resist pattern.

[3] The resist pattern formation method according to [2], wherein the line parts of the second resist pattern are formed on the space parts of the insolubilized resist pattern in parallel to the line parts of the insolubilized resist pattern.

[4] The resist pattern formation method according to [2], wherein the line parts of the second resist pattern are formed on the space parts of the insolubilized resist pattern to form a contact hole pattern possessing contact holes which are partitioned by the line parts of the insolubilized resist pattern and the line parts of the second resist pattern.

[5] The resist pattern formation method according to [1], wherein the insolubilized resist pattern and the second resist pattern are respectively line-and-space patterns each having line parts and space parts and the method further comprises forming the line parts of the second resist pattern on the line parts of the insolubilized resist pattern so as to cause the line parts of the second resist pattern to cross the line parts of the insolubilized resist pattern.

[6] The resist pattern formation method according to [1], wherein at least one of the first positive-tone radiation-sensitive resin composition and the second positive-tone radiation-sensitive resin composition comprises a resin having a repeating unit shown by the following general formula (1),

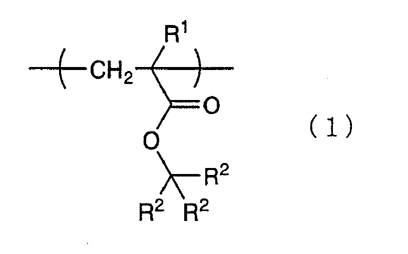

wherein R¹ represents a hydrogen atom or a methyl group and R²s individually represent a monovalent alicyclic hydrocarbon group having 4 to 20 carbon atoms, a derivative thereof, or a linear or branched alkyl group having 1 to 4 carbon atoms, or (i) at least one of the R²s represents a monovalent alicyclic hydrocarbon group having 4 to 20 carbon atoms or a derivative thereof, or (ii) any two of the R²s bond with each other to form a divalent alicyclic hydrocarbon group having 4 to 20 carbon atoms including the carbon atom to which the R²s bond, or a derivative thereof, with the remaining R² being a linear or branched alkyl group having 1 to 4 carbon atoms, a monovalent alicyclic hydrocarbon group having 4 to 20 carbon atoms, or a derivative thereof.

[7] A resist pattern insolubilizing resin composition used in the step (2) of the resist pattern formation method according to any one of [1] to [6], comprising a resin having a hydroxyl group and an alcohol solvent and capable of insolubilizing the first resist pattern in a developer and the second positive-tone radiation-sensitive resin composition.

[8] The resist pattern insolubilizing resin composition according to [7], wherein the alcohol solvent is a nonaqueous solvent which contains an alcohol or an alcohol-containing solvent having a water content of 10 mass% or less.

[9] The resist pattern insolubilizing resin composition according to [8], wherein the alcohol is a monohydric alcohol having 1 to 8 carbon atoms.

[10] The resist pattern insolubilizing resin composition according to [7], further comprising a crosslinking component.

[11] The resist pattern insolubilizing resin composition according to [10], wherein the crosslinking component is at least one of a compound having a group shown by the following general formula (2) and a compound having two or more cyclic ether reactive groups,

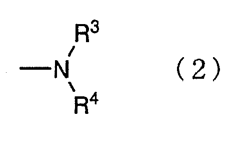

wherein R³ and R⁴ individually represent a hydrogen atom or a group shown by the following general formula (3), provided that at least one of R³ and R⁴ represents a group shown by the following general formula (3),

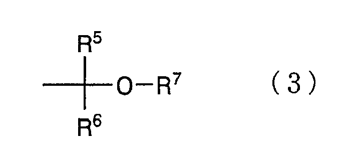

wherein R⁵ and R⁶ individually represent a hydrogen atom, an alkyl group having 1 to 6 carbon atoms, an alkoxyalkyl group having 1 to 6 carbon atoms, or R⁵ and R⁶ bond together to form a ring having 2 to 10 carbon atoms, and R⁷ represents a hydrogen atom or an alkyl group having 1 to 6 carbon atoms.

[12] The resist pattern insolubilizing resin composition according to [7], wherein the resin having a hydroxyl group is obtained by polymerizing a monomer component which contains at least one of hydroxyacrylanilide and hydroxymethacrylanilide.

[13] The resist pattern insolubilizing resin composition according to [12], wherein the resin having a hydroxyl group comprises a repeating unit shown by the following general formula (4),

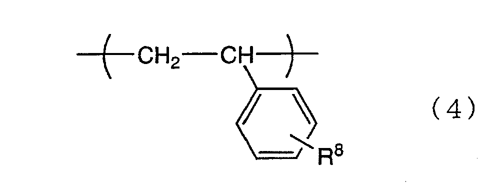

wherein R⁸ represents a hydrogen atom, a linear or branched alkyl group having 1 to 8 carbon atoms, or a linear or branched alkoxy group having 1 to 8 carbon atoms.

[14] The resist pattern insolubilizing resin composition according to [7], wherein the second positive-tone radiation-sensitive resin composition contains at least one of an iodonium salt compound and a sulfonium salt compound which can generate a base by decomposing upon exposure to radiation.

According to the method for forming a resist pattern of the present invention, fine patterns can be formed efficiently by a simple means.

Fine patterns can be formed efficiently by a simple means by using the resist pattern insolubilizing resin composition of the present invention.

### BRIEF DESCRIPTION OF THE DRAWINGS

Figure 1 is a cross-sectional view schematically showing an example of the first pattern.
Figure 2 is a cross-sectional view schematically showing an example of an insolubilized resist pattern.
Figure 3 is a plan view schematically showing an example of an insolubilized resist pattern.
Figure 4 is a cross-sectional view schematically showing an example in which a second resist layer has been formed on the insolubilized resist pattern.
Figure 5 is a plan view schematically showing an example in which line parts of a second resist pattern have been formed on the space parts of the insolubilized resist pattern.
Figure 6 is a plan view schematically showing another example in which line parts of a second resist pattern have been formed on the space parts of the insolubilized resist pattern.
Figure 7 is a plan view schematically showing an example in which line parts of a second resist pattern have been formed on the line parts of the insolubilized resist pattern.
Figure 8 is a side elevation view schematically showing an example in which line parts of a second resist pattern have been formed on the line parts of the insolubilized resist pattern.

### EXPLANATION OF SYMBOLS

1: first resist pattern, 1a: first line part, 1b: first space part, 2, 22, 32: second resist patterns, 2a, 22a, 32a: second line parts, 2b, 22b, 32b: second space parts, 3: insolubilized resist pattern, 5: insoluble film, 10: substrate, 12: second resist layer, 15: contact hole

### BEST MODE FOR CARRYING OUT THE INVENTION

The preferred embodiments for carrying out the present invention are described below. However, the present invention is not restricted to the following embodiments and it should be construed that there are also included, in the present invention, those embodiments in which appropriate changes, improvements, etc. have been made to the following embodiments based on the ordinary knowledge possessed by those skilled in the art, as long as there is no deviation from the gist of the present invention. In the description hereinafter, "first positive-tone radiation-sensitive resin composition" and "second positive-tone radiation-sensitive resin composition" are respectively referred to from time to time simply as "first resist agent" and "second resist agent" and "resist pattern insolubilizing resin composition" is referred to from time to time simply as "insolubilizing resin composition".

### 1. Resist pattern insolubilizing resin composition

### (Resin containing hydroxyl group)

It is preferable that the resin containing a hydroxyl group included in the insolubilizing resin composition of the present invention (hereinafter referred to from time to time as "hydroxyl group-containing resin") has at least one hydroxyl group (-OH) selected from hydroxyl groups originating from an alcohol, a phenol, or a carboxylic acid.

The hydroxyl group-containing resin can be obtained by copolymerizing monomer components which include at least one monomer having a hydroxyl group selected from the group consisting of an alcoholic hydroxyl group, a hydroxyl group originating from an organic acid such as a carboxylic acid, and a phenolic hydroxyl group. As specific examples of the monomer containing an alcoholic hydroxyl group, hydroxyalkyl (meth)acrylates such as 2-hydroxyethyl acrylate, 2-hydroxyethyl methacrylate, 2-hydroxypropyl acrylate, 2-hydroxypropyl methacrylate, 4-hydroxybutyl acrylate, 4-hydroxybutyl methacrylate, glycerol monomethacrylate, and the like can be given. Of these, 2-hydroxyethyl acrylate and 2-hydroxyethyl methacrylate are preferable. These monomers may be used either individually or in combination of two or more. The proportion of the monomers having the alcoholic hydroxyl group is usually 5 to 90 mol%, and preferably 10 to 60 mol% of the total amount of monomers from which the hydroxyl group-containing resin is produced.

As specific examples of the monomers containing a hydroxyl group originating from an organic acid such as carboxylic acid, monocarboxylic acids such as acrylic acid, methacrylic acid, crotonic acid, 2-succinoloylethyl (meth)acrylate, 2-maleinoloylethyl (meth)acrylate, 2-hexahydrophthaloylethyl (meth)acrylate, omega-carboxypolycaprolactone monoacrylate, monohydroxyethyl phthalate acrylate, acrylic acid dimer, 2-hydroxy-3-phenoxypropyl acrylate, t-butoxy methacrylate, and t-butyl acrylate; (meth)acrylic acid derivatives having a carboxyl group such as dicarboxylic acid such as maleic acid, fumaric acid, citraconic acid, mesaconic acid, or itaconic acid; and the like can be given. Of these, acrylic acid, methacrylic acid, and 2-hexahydrophthaloylethyl methacrylate are preferable. These monomers may be used either individually or in combination of two or more. The proportion of these monomers is usually 5 to 90 mol%, and preferably 10 to 60 mol% in the total amount of monomers which form the hydroxyl group-containing resin.

As a commercially-available product of omega-carboxypolycaprolactone monoacrylate, "Aronix M-5300"manufactured by Toagosei Co., Ltd. can be given. As a commercially-available product of an acrylic acid dimer, "Aronix M-5600"manufactured by Toagosei Co., Ltd. can be given. As a commercially-available product of 2-hydroxy-3-phenoxypropylacrylate, "Aronix M-5700"manufactured by Toagosei Co., Ltd. can be given.

As examples of the monomer containing a phenolic hydroxyl group, p-hydroxystyrene, m-hydroxystyrene, o-hydroxystyrene, α-methyl-p-hydroxystyrene, α-methyl-m-hydroxystyrene, α-methyl-o-hydroxystyrene, 2-allylphenol, 4-allylphenol, 2-allyl-6-methylphenol, 2-allyl-6-methoxyphenol, 4-allyl-2-methoxyphenol, 4-allyl-2,6-dimethoxyphenol, 4-allyloxy-2-hydroxybenzophenone, and the like can be given. Of these, p-hydroxystyrene and α-methyl-p-hydroxystyrene are preferable.

As the monomer having a phenolic hydroxyl group, a monomer having an amide bond (an amide group) in the molecule is preferable. As preferable examples of such a monomer, monomers shown by the following general formula (5) can be given.

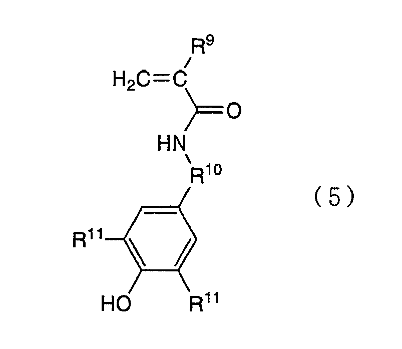

wherein R⁹ and R¹¹ individually represent a hydrogen atom or a methyl group and R¹⁰ represents a single bond or a linear or cyclic divalent hydrocarbon group. As specific examples of R¹⁰, saturated chain hydrocarbon groups such as a methylene group, ethylene group, propylene group (1,3-propylene group, 1,2- propylene group), tetramethylene group, pentamethylene group, hexamethylene group, heptamethylene group, octamethylene group, nonamethylene group, decamethylene group, undecamethylene group, dodecamethylene group, tridecamethylene group, tetradecamethylene group, pentadecamethylene group, hexadecamethylene group, heptadecamethylene group, octadecamethylene group, nonadecamethylene group, icosylene group, 1-methyl-1,3-propylene group, 2-methyl-1,3-propylene group, 2-methyl-1,2-propylene group, 1-methyl-1,4-butylene group, 2-methyl-1,4-butylene group, ethylidene group, propylidene group, and 2-propylidene group; monocyclic hydrocarbon groups such as cycloalkylene groups having 3 to 10 carbon atoms such as cyclobutylene groups (e.g. a 1,3-cyclobutylene group), cyclopentylene groups (e.g. a 1,3-cyclopentylene group), cyclohexylene groups (e.g. a 1,4-cyclohexylene group), and cyclooctylene groups (e.g. a 1,5-cyclooctylene group); bridged cyclic hydrocarbon groups such as cyclic hydrocarbon groups with 2 to 4 rings having 4 to 30 carbon atoms such as a norbornylene groups (e.g. 1,4-norbornylene group, 2,5-norbornylene group), and admantylene groups (e.g. 1,5-admantylene group, 2,6-admantylene group); and the like can be given. As the monomer shown by the general formula (5), p-hydroxymethacrylanilide is preferable. The proportion of the monomers having a phenolic hydroxyl group shown by the general formula (5) is usually 30 to 95 mol%, and preferably 40 to 90 mol% of the total amount of monomers forming the hydroxyl group-containing resin.

A monomer having a specific functional group which can be converted into a phenolic hydroxyl group after copolymerization (specific functional group-containing monomer) may also be used. As specific examples of the specific functional group-containing monomer, p-acetoxystyrene, α-methyl-p-acetoxystyrene, p-benzyloxystyrene, p-tert-butoxystyrene, p-tert-butoxycarbonyloxystyrene, p-tert-butyldimethylsiloxystyrene, and the like can be given. The specific group in the resin obtained by copolymerizing the specific functional group-containing monomers can be easily converted into a phenolic hydroxyl group by a suitable treatment such as hydrolysis using hydrochloric acid or the like. The proportion of the specific functional group-containing monomers is usually 5 to 90 mol%, and preferably 10 to 80 mol% in the total amount of monomers which form the hydroxyl group-containing resin.

The proportion of the monomers having an alcoholic hydroxyl group, the monomers having a hydroxyl group originating from an organic acid such as a carboxylic group, and the monomers having a phenolic hydroxyl group in the total amount of the monomers forming the hydroxyl group-containing resin is usually within the range mentioned above for each of the monomers. If the proportion of the structural unit having a hydroxyl group is too small, shrinkage of the resist pattern occurs only with difficulty due to a small amount of reactive sites with the crosslinking component which is described later. If the proportion of the structural unit having a hydroxyl group is too large, the resist may swell and bury the resist pattern during development.

The hydroxyl group-containing resin is preferably a resin including a repeating unit shown by the following general formula (4),

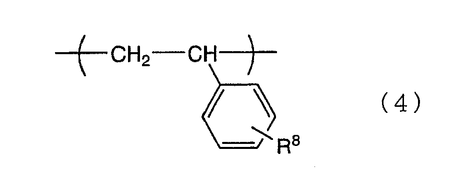

wherein R⁸ represents a hydrogen atom, a linear or branched alkyl group having 1 to 8 carbon atoms, or a linear or branched alkoxy group having 1 to 8 carbon atoms. R⁸ preferably represents a tert-butyl group, an acetoxy group, or a 1-ethoxyethoxy group, with a tert-butyl group being particularly preferable. The repeating unit shown by the general formula (4) can be obtained by copolymerizing using a styrene derivative as a monomer. A preferable styrene derivative used as a monomer in that reaction is tert-butoxystyrene.

When producing the hydroxyl group-containing resin, other monomers may be copolymerized in order to control hydrophilicity and solubility of the resin. As specific examples of the other monomers, (meth)acrylic acid aryl esters, dicarboxylic acid diesters, nitrile group-containing polymerizable compounds, amide bond-containing polymerizable compounds, vinyl compounds, allyl compounds, chlorine-containing polymerizable compounds, conjugated diolefins, and the like can be given. Specific examples include dicarboxylic acid diesters such as diethyl maleate, diethyl fumarate, and diethyl itaconate; (meth)acrylic acid aryl esters such as phenyl (meth)acrylate and benzyl (meth)acrylate; aromatic vinyl compounds such as styrene, α-methylstyrene, m-methylstyrene, p-methylstyrene, vinyltoluene, p-methoxystyrene, and p-t-butoxystyrene; (meth)acrylates such as t-butyl (meth)acrylate and 4,4,4-trifluoro-3-hydroxy-1-methyl-3-trifluoromethyl-1-butyl (meth)acrylate; nitrile group-containing polymerizable compounds such as acrylonitrile and methacrylonitrile; amide bond-containing polymerizable compounds such as acrylamide and methacrylamide; fatty-acid vinyl compounds such as vinyl acetate; chlorine-containing polymerizable compounds such as vinyl chloride and vinylidene chloride; conjugated diolefins such as 1,3-butadiene, isoprene, and 1,4-dimethylbutadiene; and the like can be given. These monomers may be used either individually or in combination of two or more.

As preferable specific examples of "other monomers", compounds shown by the following general formula (11) can be given.

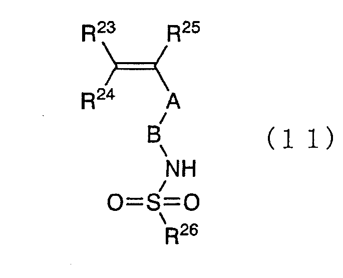

wherein R²³, R²⁴, and R²⁵ individually represent a hydrogen atom, an alkyl group having 1 to 10 carbon atoms, a hydroxymethyl group, a trifluoromethyl group, or a phenyl group, A represents a single bond, an oxygen atom, a carbonyl group, a carbonyloxy group, or an oxycarbonyl group, B represents a single bond or a divalent organic group having 1 to 20 carbon atoms, and R²⁶ represents a monovalent organic group.

As examples of the alkyl group having 1 to 10 carbon atoms represented by R²³, R²⁴, and R²⁵ in the general formula (11), a methyl group, an ethyl group, a propyl group, a butyl group, a pentyl group, a hexyl group, a heptyl group, an octyl group, a nonyl group, and a decyl group can be given. Hydrogen atoms are preferable as R¹ and R² and a hydrogen atom or a methyl group is preferable as R³.

In the general formula (11), R²⁶ represents a monovalent organic group, and preferably a monovalent organic group containing a fluorine atom. R²⁶ is preferably a fluoroalkyl group having 1 to 20 carbon atoms, and more preferably a fluoroalkyl group having 1 to 4 carbon atoms.

As specific examples of fluoroalkyl group having 1 to 20 carbon atoms, a difluoromethyl group, a perfluoromethyl group, a 1,1-difluoroethyl group, a 2,2-difluoroethyl group, a 2,2,2-trifluoroethyl group, a perfluoroethyl group, a 1,1,2,2-tetrafluoropropyl group, a 1,1,2,2,3,3-hexafluoropropyl group, a perfluoroethylmethyl group, a 1-(trifluoromethyl)-1,2,2,2-tetrafluoroethyl group, a perfluoropropyl group, a 1,1,2,2-tetrafluorobutyl group, a 1,1,2,2,3,3-hexafluorobutyl group, a 1,1,2,2,3,3,4,4-octafluorobutyl group, a perfluorobutyl group, a 1,1-bis(trifluoro)methyl-2,2,2-trifluoroethyl group, a 2-(perfluoropropyl)ethyl group, a 1,1,2,2,3,3,4,4-octafluoropentyl group, a perfluoropentyl group, a 1,1,2,2,3,3,4,4,5,5-decafluoropentyl group, a 1,1-bis(trifluoromethyl)-2,2,3,3,3-pentafluoropropyl group, a perfluoropentyl group, a 2-(perfluorobutyl)ethyl group, 1,1,2,2,3,3,4,4,5,5-decafluorohexyl group, a 1,1,2, 2,3,3,4,4,5,5,6,6-dodecafluorohexyl group, a perfluoropentylmethyl group, a perfluorohexyl group, a 2-(perfluoropentyl)ethyl group, 1,1,2,2,3,3,4,4,5,5,6,6-dodecafluoroheptyl group, a perfluorohexylmethyl group, a perfluoroheptyl group, 2-(perfluorohexyl) ethyl group, a 1,1,2,2,3,3,4,4,5,5,6,6,7,7-tetradecafluorooctyl group, a perfluoroheptylmethyl group, a perfluorooctyl group, a 2-(perfluoroheptyl)ethyl group, a 1,1,2,2,3,3,4,4,5,5,6,6,7,7,8,8-hexadecafluorononyl group, a perfluorooctylmethyl group, a perfluorononyl group, 2-(perfluorooctyl)ethyl group, a 1,1,2,2,3,3,4,4,5,5,6,6,7,7,8,8,9,9-octadecafluorodecyl group, a perfluorononylmethyl group, and a perfluorodecyl group can be given.

Among the specific examples of the fluoroalkyl group having 1 to 20 carbon atoms, the fluoroalkyl groups having too large a carbon atom content tend to have low solubility in an alkaline aqueous solution. For this reason, a perfluoromethyl group, a perfluoroethyl group, and a perfluoropropyl group are preferable among the fluoroalkyl groups having 1 to 20 carbon atoms.

Among the groups represented by B in the general formula (11), as specific examples of the divalent organic group having 1 to 20 carbon atoms, saturated chain hydrocarbon groups such as a methylene group, an ethylene group, a propylene group such as a 1,3-propylene group and a 1,2- propylene group, a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, a tetradecamethylene group, a pentadecamethylene group, a hexadecamethylene group, a heptadecamethylene group, an octadecamethylene group, a nonadecamethylene group, an icosylene group, a 1-methyl-1,3-propylene group, a 2-methyl-1,3-propylene group, a 2-methyl-1,2-propylene group, a 1-methyl-1,4-butylene group, a 2-methyl-1,4-butylene group, a methylidene group, an ethylidene group, a propylidene group, and a 2-propylidene group; monocyclic hydrocarbon groups such as cycloalkylene groups having 3 to 10 carbon atoms such as cyclobutylene groups (e.g. a 1,3-cyclobutylene group), cyclopentylene groups (e.g. a 1,3-cyclopentylene group), cyclohexylene groups (e.g. a 1,4-cyclohexylene group), and cyclooctylene groups (e.g. a 1,5-cyclooctylene group); bridged cyclic hydrocarbon groups such as cyclic hydrocarbon groups with 2 to 4 rings having 4 to 30 carbon atoms such as norbornylene groups (e.g. a 1,4-norbornylene group, a 2,5-norbornylene group), and admantylene groups (e.g. a 1,5-admantylene group, a 2,6-admantylene group); and the like can be given.

As preferable examples of the "other monomers" represented by the general formula (11), 2-(((trifluoromethyl)sulfonyl)amino)ethyl-1-methacrylate, 2-(((trifluoromethyl)sulfonyl)amino)ethyl-1-acrylate, and compounds shown by the following formulas (11-1) to (11-6) can be given.

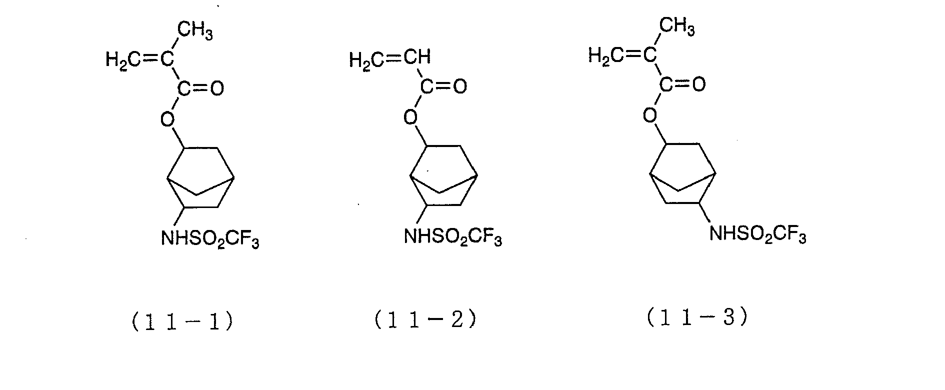

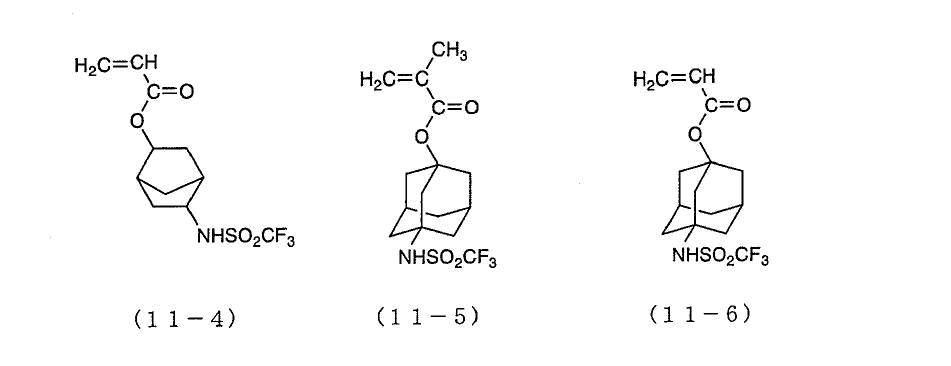

The proportion of the "other monomers" shown by the general formula (11) is usually 1 to 50 mol%, and preferably 2 to 30 mol%, and more preferably 2 to 20 mol% of the total amount of monomers forming the hydroxyl group-containing resin.

### (Method for producing hydroxyl group-containing resin)

The hydroxyl group-containing resin can be produced by polymerizing a mixture of the monomers in an appropriate solvent in the presence of a chain transfer agent, as required, using a radical polymerization initiator such as a hydroperoxide, a dialkyl peroxide, a diacyl peroxide, an azo compound, or the like. As examples of the solvent which can be used for the polymerization, alkanes such as n-pentane, n-hexane, n-heptane, n-octane, n-nonane, and n-decane; cycloalkanes such as cyclohexane, cycloheptane, cyclooctane, decalin, and norbornane; aromatic hydrocarbons such as benzene, toluene, xylene, ethylbenzene, and cumene; halogenated hydrocarbons such as chlorobutanes, bromohexanes, dichloroethanes, hexamethylene dibromide, and chlorobenzene; saturated carboxylic acid esters such as ethyl acetate, n-butyl acetate, i-butyl acetate, methyl propionate, and propylene glycol monomethyl ether acetate; alkyllactones such as γ-butyrolactone; ethers such as tetrahydrofuran, dimethoxyethanes, and diethoxyethanes; alkylketones such as 2-butanone, 2-heptanone, and methyl isobutyl ketone; cycloalkylketones such as cyclohexanone; alcohols such as 2-propanol, 1-butanol, 4-methyl-2-pentanol, and propylene glycol monomethyl ether; and the like can be given. These solvents may be used either individually or in combination of two or more.

The polymerization temperature is usually from 40 to 120°C, and preferably from 50 to 100°C. The reaction time is usually from 1 to 48 hours, and preferably from 1 to 24 hours.

It is preferable that the hydroxyl group-containing resin have a high purity. Not only is the content of impurities such as halogens or metals preferably small, but also the content of residual monomers and oligomers is preferably less than the prescribed amount, for example, the content determined by HPLC is preferably 0.1 mass% or less. Use of an insolubilizing resin composition containing a hydroxyl group-containing resin having a high purity ensures improvement of the process stability and production of resist pattern shapes with higher precision. The following methods can be given as the method for purification of the hydroxyl group-containing resin. As a method for removing impurities such as metals, a method of causing metals in the polymer solution to be adsorbed using a zeta-potential filter, a method of causing metals to be in a chelate state by washing the polymer solution with an acidic aqueous solution such as oxalic acid or sulfonic acid aqueous solution and removing the metals, and the like can be given. As a method for removing the residual monomers and oligomer components to reduce their content to a concentration not more than a specific value, a liquid-liquid extraction method in which the residual monomers and oligomer components are removed by washing with water or a combination of suitable solvents, a purification method in a solution state such as ultrafiltration in which only the monomers and oligomer components having a specific molecular weight or less are extracted and removed, a reprecipitation method in which the residual monomers and the like are removed by adding the polymer solution to a poor solvent dropwise, thereby causing the polymer to coagulate in the poor solvent, a purification method in a solid state in which the resin slurry separated by filtration is washed with a poor solvent, and the like can be given. These methods may be used in combination.

The polystyrene-reduced weight average molecular weight (Mw) of the hydroxyl group-containing resin determined by gel permeation chromatography (GPC) is usually 1,000 to 500,000, preferably 1,000 to 50,000, and more preferably 1,000 to 20,000. If the molecular weight is too large, there is a tendency for it to be difficult to remove the resin using a developer after curing with heat. If the molecular weight is too small, a uniform coating film may not be formed after application.

### (Alcohol Solvent)

The alcohol solvent included in the insolubilizing resin composition of the present invention contains an alcohol. Any alcohol solvents which can sufficiently dissolve the hydroxyl group-containing resin and the crosslinking components, which are optionally used in the resin composition, but do not dissolve the first resist pattern produced by the first resist agent can be used. As the alcohol contained in the alcohol solvent having such properties, monohydric alcohols having 1 to 8 carbon atoms are preferable. As specific examples of such a solvent, 1-propanol, isopropanol, 1-butanol, 2-butanol, tert-butanol, 1-pentanol, 2-pentanol, 3-pentanol, 2-methyl-1-butanol, 3-methyl-1-butanol, 3-methyl-2-butanol, 1-hexanol, 2-hexanol, 3-hexanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 1-heptanol, 2-heptanol, 2-methyl-2-heptanol, 2-methyl-3-heptanol, and the like can be given. Of these, 1-butanol, 2-butanol, and 4-methyl-2-pentanol are preferable. These alcohols may be used either individually or in combination of two or more.

The water content of the alcohol solvent (proportion of water in the total amount of the solvent) is preferably 10 mass% or less, and more preferably 3 mass% or less. If the water content of the alcohol solvent is exceeding 10 mass%, solubility of the hydroxyl group-containing resin tends to be poor. A particularly preferable alcohol solvent is a non-aqueous solvent containing an alcohol (substantially water-free anhydrous alcohol solvent).

### (Other components)

A solvent other than the alcohol solvent (other solvents) may be mixed in the insolubilizing resin composition of the present invention in order to adjust applicability when applying onto the first resist pattern. As the other solvent, a solvent which does not erode the first resist pattern and has an effect of allowing uniform application of the insolubilizing resin composition can be used.

Specific examples of the other solvents include cyclic ethers such as tetrahydrofuran and dioxane; alkyl ethers of polyhydric alcohol such as ethylene glycol monomethyl ether, ethylene glycol monoethyl ether, ethylene glycol dimethyl ether, ethylene glycol diethyl ether, diethylene glycol monomethyl ether, diethylene glycol monoethyl ether, diethylene glycol dimethyl ether, diethylene glycol diethyl ether, diethylene glycol ethyl methyl ether, propylene glycol monomethyl ether, and propylene glycol monoethyl ether; alkyl ether acetates of polyhydric alcohol such as ethylene glycol ethyl ether acetate, diethylene glycol ethyl ether acetate, propylene glycol ethyl ether acetate, and propylene glycol monomethyl ether acetate; aromatic hydrocarbons such as toluene and xylene; ketones such as acetone, methyl ethyl ketone, methyl isobutyl ketone, cyclohexanone, 4-hydroxy-4-methyl-2-pentanone, and diacetone alcohol; and esters such as ethyl acetate, butyl acetate, ethyl 2-hydroxypropionate, ethyl 2-hydroxy-2-methylpropionate, ethyl 2-hydroxy-2-methylpropionate, ethoxyethyl acetate, ethyl hydroxyacetate, methyl 2-hydroxy-3-methylbutanoate, methyl 3-methoxypropionate, ethyl 3-methoxypropionate, ethyl 3-ethoxypropionate, methyl 3-ethoxypropionate, ethyl acetate, and butyl acetate; water; and the like. Of these, cyclic ethers, alkyl ether of polyhydric alcohol, alkyl ether acetates of polyhydric alcohol, ketones, esters, and water are preferable.

The amount of the other solvents is usually 30 mass% or less, and preferably 20 mass% or less of the total solvent. If the amount of the other solvents is exceeding 30 mass%, the first resist pattern may be eroded and problems such as intermixing with the insolubilizing resin composition may occur. In some cases, the first resist pattern may be buried. When water is used as the other solvents, the amount is preferably 10 mass% or less.

### (Crosslinking components)

The crosslinking component is preferably a compound having a group shown by the following general formula (2) (hereinafter referred to from time to time as "crosslinking component I") or a compound having two or more cyclic ether reactive groups (hereinafter referred to from time to time as "crosslinking component II"). It is also preferable that the crosslinking component contains both the crosslinking component I and the crosslinking component II.

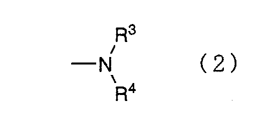

wherein R³ and R⁴ individually represent a hydrogen atom or a group shown by the following general formula (3), provided that at least one of R² and R³ represents a group shown by the following general formula (3),

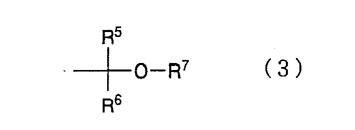

wherein R⁵ and R⁶ individually represent a hydrogen atom, an alkyl group having 1 to 6 carbon atoms, an alkoxyalkyl group having 1 to 6 carbon atoms, or R⁵ and R⁶ bond together to form a ring having 2 to 10 carbon atoms, and R⁷ represents a hydrogen atom or an alkyl group having 1 to 6 carbon atoms. The crosslinking component has an effect of curing the hydroxyl group-containing resin by reacting with the hydroxyl group-containing resin and/or reacting by itself by the action of an acid.

As a specific example of the crosslinking component I, a compound having a functional group such as an imino group, a methylol group, and a methoxymethyl group in the molecule can be given. As more specific examples, nitrogen-containing compounds prepared by alkyl-etherification of all or a part of active methylol groups of a compound such as (poly)methylolized melamine, (poly)methylolized glycoluril, (poly)methylolized benzoguanamine, (poly)methylolized urea, and the like can be given. As the alkyl group, a methyl group, an ethyl group, a butyl group, and a mixture of these groups can be given. The nitrogen-containing compounds may include an oligomer component produced by self condensation of a part thereof. As specific examples of the nitrogen-containing compound, hexamethoxymethylated melamine, hexabutoxymethylated melamine, tetramethoxymethylated glycoluril, tetrabutoxymethylated glycoluril, and the like can be given.

Among the specific examples of the crosslinking component I, as commercially available compounds, Cymel 300, Cymel 301, Cymel 303, Cymel 350, Cymel 232, Cymel 235, Cymel 236, Cymel 238, Cymel 266, Cymel 267, Cymel 285, Cymel 1123, Cymel 1123-10, Cymel 1170, Cymel 370, Cymel 771, Cymel 272, Cymel 1172, Cymel 325, Cymel 327, Cymel 703, Cymel 712, Cymel 254, Cymel 253, Cymel 212, Cymel 1128, Cymel 701, Cymel 202, and Cymel 207(manufactured by Nihon Cytec Industries, Inc.), Nikalac MW-30M, Nikalac MW-30, Nikalac MW-22, Nikalac MW-24X, Nikalac MS-21, Nikalac MS-11, Nikalac MS-001, Nikalac MX-002, Nikalac MX-730, Nikalac MX-750, Nikalac MX-708, Nikalac MX-706, Nikalac MX-042, Nikalac MX-035, Nikalac MX-45, Nikalac MX-410, Nikalac MX-302, Nikalac MX-202, Nikalac SM-651, Nikalac SM-652, Nikalac SM-653, Nikalac SM-551, Nikalac SM-451, Nikalac SB-401, Nikalac SB-355, Nikalac SB-303, Nikalac SB-301, Nikalac SB-255, Nikalac SB-203, Nikalac SB-201, Nikalac BX-4000, Nikalac BX-37, Nikalac BX-55H, and Nikalac BL-60 (manufactured by Sanwa Chemical Co., Ltd.), and the like can be given.
Cymel 325,Cymel 327, Cymel 703, Cymel 712, Cymel 254, Cymel 253, Cymel 212, Cymel 1128, Cymel 701, Cymel 202, and Cymel 207 which are the compounds of the general formula (1) in which either R¹ or R² is a hydrogen atom, that is, crosslinking components having an imino group, are preferable.

As specific examples of the crosslinking component II, epoxy cyclohexyl group-containing compounds such as 3,4-epoxycyclohexylmethyl-3',4'-epoxycyclohexanecarboxylate, 2-(3,4-epoxycyclohexyl-5,5-spiro-3,4-epoxy)cyclohexane-m-dioxane, bis(3,4-epoxycyclohexylmethyl)adipate, bis(3,4-epoxy-6-methylcyclohexylmethyl)adipate, 3,4-epoxy-6-methylcyclohexyl-3',4'-epoxy-6'-methylcyclohexanecarboxylate, methylenebis(3,4-epoxycyclohexane), ethylene glycol di(3,4-epoxycyclohexylmethyl) ether, ethylenebis(3,4-epoxycyclohexanecarboxylate), ε-caprolactone-modified 3,4-epoxycyclohexylmethyl-3',4'-epoxycyclohexanecarboxylate, trimethylcaprolactone-modified 3,4-epoxycyclohexylmethyl-3',4'-epoxycyclohexanecarboxylate, β-methyl-δ-valerolactone-modified 3,4-epoxycyclohexylmethyl-3',4'-epoxycyclohexanecarboxylate, and the like;

bisphenol A diglycidyl ether, bisphenol F diglycidyl ether, bisphenol S diglycidyl ether, chlorinated bisphenol A diglycidyl ether, chlorinated bisphenol F diglycidyl ether, chlorinated bisphenol S diglycidyl ether, hydrogenated bisphenol A diglycidyl ether, hydrogenated bisphenol F diglycidyl ether, hydrogenated bisphenol S diglycidyl ether, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ethers; polydiglycidyl ethers of polyether polyol obtained by adding one or more alkylene oxides to an aliphatic polyhydric alcohol such as ethylene glycol, propylene glycol, and glycerol; diglycidyl esters of an aliphatic long-chain dibasic acid;

monoglycidyl ethers of an aliphatic higher alcohol, phenol, cresol, butyl phenol, or monoglycidyl ethers of a polyether alcohol obtained by adding an alkylene oxide to the phenol, cresol, or butyl phenol; glycidyl esters of a higher fatty acid;

oxetane compounds having two or more oxetane rings in the molecule such as 3,7-bis(3-oxetanyl)-5-oxa-nonane, 3,3'-(1,3-(2-methylenyl)propanediylbis(oxymethylene))bis-(3-ethyloxetane), 1,4-bis[(3-ethyl-3-oxetanylmethoxy)methyl]benzene, 1,2-bis[(3-ethyl-3-oxetanylmethoxy)methyl]ethane, 1,3-bis[(3-ethyl-3-oxetanylmethoxy)methy]propane, ethylene glycol bis(3-ethyl-3-oxetanylmethyl) ether, dicyclopentenyl bis(3-ethyl-3-oxetanylmethyl) ether, triethylene glycol bis(3-ethyl-3-oxetanylmethyl) ether, tetraethylene glycol bis(3-ethyl-3-oxetanylmethyl) ether, tricyclodecanediyldimethylene(3-ethyl-3-oxetanylmethyl) ether, trimethylolpropane tris(3-ethyl-3-oxetanylmethyl) ether, 1,4-bis(3-ethyl-3-oxetanylmethoxy)butane, 1,6-bis(3-ethyl-3-oxetanylmethoxy)hexane, pentaerythritol tris(3-ethyl-3-oxetanylmethyl) ether, pentaerythritol tetrakis(3-ethyl-3-oxetanylmethyl) ether, polyethylene glycol bis(3-ethyl-3-oxetanylmethyl) ether, dipentaerythritol hexakis(3-ethyl-3-oxetanylmethyl) ether, dipentaerythritol pentakis(3-ethyl-3-oxetanylmethyl) ether, dipentaerythritol tetrakis(3-ethyl-3-oxetanylmethyl) ether, caprolactone-modified dipentaerythritol hexakis(3-ethyl-3-oxetanylmethyl) ether, caprolactone-modified dipentaerythritol pentakis(3-ethyl-3-oxetanylmethyl) ether, ditrimethylolpropane tetrakis(3-ethyl-3-oxetanylmethyl) ether, EO-modified bisphenol A bis(3-ethyl-3-oxetanylmethyl) ether, PO-modified bisphenol A bis(3-ethyl-3-oxetanylmethyl) ether, EO-modified hydrogenated bisphenol A bis(3-ethyl-3-oxetanylmethyl) ether, PO-modified hydrogenated bisphenol A bis(3-ethyl-3-oxetanylmethyl) ether, EO-modified bisphenol F (3-ethyl-3-oxetanylmethyl) ether, and the like can be given.

Of these, 1,6-hexanediol diglycidyl ether and dipentaerythritol hexakis(3-ethyl-3-oxetanylmethyl) ether are preferable as the crosslinking component II. These crosslinking components may be used either individually or in combination of two or more. As examples of commercially available products among the specific examples of the crosslinking component II, ARONOXETANE OXT-101, OXT-121, and OXT-221 (manufactured by Toagosei Co., Ltd.), OXTP and OXBP (manufactured by Ube Industries, Ltd.), and the like can be given.

The amount of the crosslinking component contained in the insolubilizing resin composition of the present invention is preferably 1 to 100 parts by mass, and more preferably 5 to 70 parts by mass for 100 parts by mass of the hydroxyl group-containing resin. If below 1 part by mass, curing may be insufficient, resulting in a tendency of making it difficult for the resist pattern to shrink. On the other hand, if exceeding 100 parts by mass, there may be a case in which the resist pattern is buried.

The total amount of the hydroxyl group-containing resin and the crosslinking component in the total amount of the insolubilizing resin composition including the non-aqueous solvent and the alcohol solvent is preferably 0.1 to 30 mass%, and more preferably 1 to 20 mass%. If the total amount of the hydroxyl group-containing resin and the crosslinking component is below 0.1 mass%, the coated film will be too thin which may cause film cut in the pattern edges. If exceeding 30 mass%, on the other hand, the viscosity is too high for fine patterns to be buried.

### (Surfactant)

A surfactant can be added to the insolubilizing resin composition of the present invention in order to increase applicability, defoamability, leveling properties, and the like. As specific examples of the surfactant which may be added, commercially available fluorine-containing surfactants such as BM-1000, BM-1100 (manufactured by BM Chemie), Megafac F142D, F172, F173, F183 (manufactured by Dainippon Ink and Chemicals, Inc.), Fluorad FC-135, FC-170C, FC-430, FC-431 (manufactured by Sumitomo 3M, Ltd.), Surflon S-112, S-113, S-131, S-141, S-145 (manufactured by Asahi Glass Co., Ltd.), SH-28PA, SH-190, SH-193, SZ-6032, SF-8428 (manufactured by Toray-Dow Coming Silicone Co., Ltd.), and the like can be given. The amount of the surfactant to be added is preferably 5 parts by mass or less for 100 parts by mass of the hydroxyl group-containing resin.

### 2. Resist pattern formation method:

### (Step (1))

In the step (1), a first resist agent is applied to a silicon wafer or a substrate covered with a SiN film, organic antireflection film, or the like by a method such as rotational coating, cast coating, or roll coating. A first resist layer consisting of the first resist agent can be formed in this manner. After applying the first resist agent, the coated film may be optionally prebaked (PB) to vaporize the solvent from the film. The prebaking conditions are appropriately selected according to the composition of the first resist agent in a range usually from 30 to 200°C, and preferably 50 to 150°C.

In order to bring out the potential of the first resist agent to the maximum extent, an organic or inorganic antireflection film may be formed on the substrate as disclosed in Japanese Patent Application Examined Publication No. 6-12452, for example. In addition, a protective film may be provided on the first resist layer in order to prevent an adverse effect of basic impurities and the like that are present in the environmental atmosphere using a method described in, for example, Japanese Patent Application Laid-open No. 5-188598. It is also preferable to provide both the antireflection film and the protective film.

Then, a selected area on the first resist layer thus formed is exposed to radiation through a mask with a predetermined pattern to obtain a pattern latent image region (region made insoluble in alkali by exposure). As radiation used for exposure, visible rays, ultraviolet rays, deep ultraviolet rays, X-rays, electron beams, or the like are appropriately selected depending on types of the acid generator contained in the first resist agent. It is particularly preferable to use deep ultraviolet rays represented by an ArF excimer laser (wavelength: 193 nm) or a KrF excimer laser (wavelength: 248 nm). An ArF excimer laser (wavelength: 193 nm) is particularly preferable. The exposure conditions such as a radiation dose are appropriately determined depending on the composition, the type of additives, and the like of the first resist agent. In the present invention, it is preferable to perform post-exposure bake (PEB) after the exposure. The PEB ensures a smooth dissociation reaction of the acid-dissociable group contained in the resin components. The heating temperature for the PEB is usually 30 to 200°C, and preferably 50 to 170°C, although the heating conditions are changed according to the composition of the resin composition.

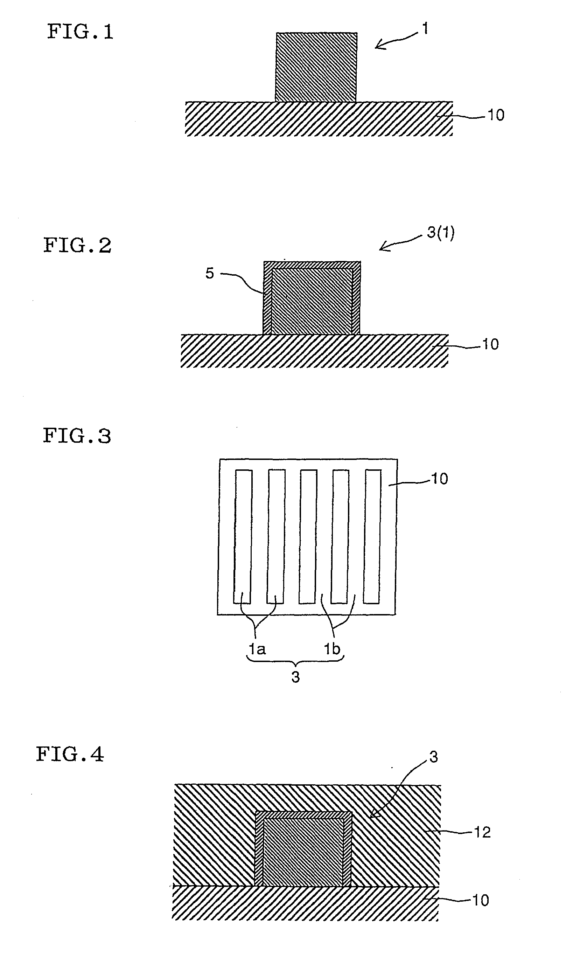

The exposed first resist layer is developed, whereby the pattern latent image parts are exposed to form a positive-tone first resist pattern 1 having specified space areas and a specified line width L₁ on the substrate 10 as shown in Figure 1. As examples of the developer that can be used for development, it is preferable to use an alkaline aqueous solution prepared by dissolving at least one alkaline compound such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, 1,5-diazabicyclo-[4.3.0]-5-nonene, and the like. The concentration of the alkaline aqueous solution is usually 10 mass% or less. If the concentration of the alkaline aqueous solution exceeds 10 mass%, an unexposed area may also be dissolved in the developer. The resist film is generally washed with water after development using the alkaline aqueous solution, and dried.

Organic solvents may be added to the alkaline aqueous solution (developer). As examples of the organic solvent which may be added, ketones such as acetone, methyl ethyl ketone, methyl i-butyl ketone, cyclopentanone, cyclohexanone, 3-methylcyclopentanone, and 2,6-dimethylcyclohexanone; alcohols such as methylalcohol, ethylalcohol, n-propylalcohol, i-propylalcohol, n-butylalcohol, t-butylalcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, dimethylformamide; and the like can be given. These organic solvents may be used either individually or in combination of two or more.

The amount of the organic solvent used is preferably 100 parts by volume or less for 100 parts by volume of the alkaline aqueous solution. The amount of the organic solvent exceeding 100 parts by volume for 100 parts by volume of the alkaline aqueous solution may decrease developability, giving rise to a larger undeveloped portion in the exposed area. An appropriate amount of a surfactant or the like may also be added to the developer.

### (Step (2))

In the step (2), the insolubilizing resin composition, which is one embodiment of the present invention, is applied onto the first resist pattern by a method such as rotational coating, cast coating, or roll coating. In this instance, the insolubilizing resin composition is applied in a manner so that the first resist pattern is covered. After coating the insolubilizing resin composition, the coated film is treated with heat (baked) or cured with UV. The coated insolubilizing resin composition is reacted with the first resist pattern by the heat treatment or UV curing. The heating temperature is usually 30 to 200°C, and preferably 50 to 170°C, although the heating conditions are changed according to the composition of the insolubilizing resin composition. On the other hand, a lamp such as an Ar₂ lamp, a KrCl lamp, a Kr₂ lamp, an XeCl lamp, and an Xe₂ lamp (manufactured by USHIO, INC.) can be used for UV curing. After appropriately cooling, the resist is developed in the same manner as in the above step (1) to obtain an insolubilized resist pattern 3 which consists of a line-and-space pattern having a first line part 1a and a first space part 1b, with the surface of the first resist pattern 1 being covered with an insolubilized film 5 of a resin composition, as shown in Figures 2 and 3. The insolubilized resist pattern 3 (the first line part 1a) that has been formed is insoluble or scarcely dissolved in a developer and the second resist agent. After development, the insolubilized resist pattern may be further hardened several times, as required, by heat treatment (PEB) or UV curing.

The first resist pattern 1 which has been insolubilized (insolubilized resist pattern 3) preserves the pattern configuration even after application of the second resist agent, exposure to radiation, and development in the following step (3) and step (4). As required, the pattern width may slightly change depending on the thickness of the insolubilized resin composition. The step (2) may be carried out two or more times as required.

### (Step (3))

In the step (3), a second resist agent is applied onto the insolubilized resist pattern 3 which was formed on the substrate 10 by a method such as rotational coating, cast coating, or roll coating to form a second resist layer 12 consisting of the second resist agent, as shown in Figure 4. After that, prebaking (PB) may be carried out as required in the same manner as in the step (1). Next, in the same manner as in the step (1), the space parts of the second resist layer 12 and, as required, the first resist pattern (insolubilized resist pattern) are selectively exposed to radiation through a mask. In addition, the resist pattern may be further treated with heat (PEB) as required.

### (Step (4))

In the step (4), the exposed resist film is developed in the same manner as in the step (1) to form a positive-tone second resist pattern. A resist pattern consisting of sequentially added first resist patterns (insolubilized resist patterns) and second resist patterns formed on the substrate can be obtained by the above steps. A semiconductor device can be fabricated using the resist pattern obtained in this manner.

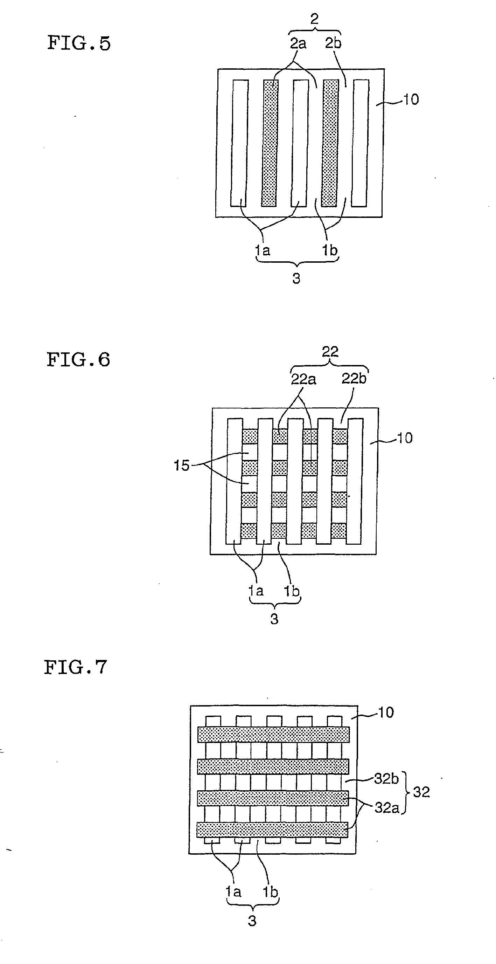

Various resist patterns having characteristic pattern arrangements can be ultimately formed by appropriately selecting mask patterns used in the selective exposure in the step (3). As shown in Figure 5, for example, when forming an insolubilized resist pattern 3 having a first line part 1a and a first space part 1b, it is possible to form a second line part 2a of the second resist pattern 2 which has the second line part 2a and a second space part 2b in the first space part 1b parallel to the first line part 1a by appropriately selecting the mask pattern used in exposure in the step (3).

In addition, as shown in Figure 6, for example, if the second line part 22a of a second resist pattern 22 which possesses a second line part 22a and a second space part 22b is formed in the first space part 1b in a check form (a go board), a resist pattern (a contact hole pattern) having contact holes 15 partitioned by the first line part 1a of the insolubilized resist pattern and the second line part 22a can be obtained.

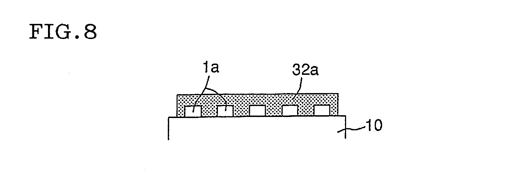

As shown in Figures 7 and 8, for example, it is possible to form a second line part 32a of the second resist pattern 32 which has the second line part 32a and the second space part 32b on the first line part 1a so as to cross the first line part 1a by selecting the mask pattern used in exposure in the step (3).

### (Positive-tone resist agent)

In both the first resist agent and the second resist agent used in the resist pattern formation method of the present invention, an acid-dissociable group is dissociated by the action of an acid generated from the photo-acid generator by exposure to radiation. As a result, the resist agent in the area exposed to radiation has increased solubility in an alkaline developer, making it possible to remove the exposed part by dissolution in an alkaline developer, thereby obtaining a positive-tone resist pattern.

It is preferable that either one of the first resist agent or the second resist agent, or both of these contain a resin having a repeating unit shown by the following general formula (1) (hereinafter referred to from time to time as "resist agent resin"),

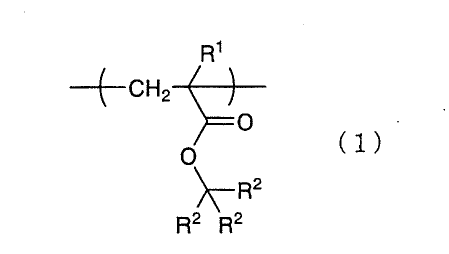

wherein R¹ represents a hydrogen atom or a methyl group and R²s individually represent a monovalent alicyclic hydrocarbon group having 4 to 20 carbon atoms, a derivative thereof, or a linear or branched alkyl group having 1 to 4 carbon atoms, or (i) at least one of the R²s represents a monovalent alicyclic hydrocarbon group having 4 to 20 carbon atoms or a derivative thereof, or (ii) any two of the R²s bond with each other to form a divalent alicyclic hydrocarbon group having 4 to 20 carbon atoms including the carbon atom to which the R²s bond, or a derivative thereof, with the remaining R² being a linear or branched alkyl group having 1 to 4 carbon atoms, a monovalent alicyclic hydrocarbon group having 4 to 20 carbon atoms, or a derivative thereof.

As specific examples of the monovalent alicyclic hydrocarbon group having 4 to 20 carbon atoms shown by R² in the general formula (1) and the divalent alicyclic hydrocarbon group having 4 to 20 carbon atoms formed by bonding of any two of the R² groups, groups containing an alicyclic ring derived from cycloalkanes such as norbornane, tricyclodecane, tetracyclododecane, adamantane, cyclobutane, cyclopentane, cyclohexane, cycloheptane, and cyclooctane; groups in which the above group containing an alicyclic ring is substituted with at least one of linear, branched, or cyclic alkyl groups having 1 to 4 carbon atoms such as a methyl group, an ethyl group, an n-propyl group, an i-propyl group, an n-butyl group, a 2-methylpropyl group, a 1-methylpropyl group, and a t-butyl group; and the like can be given. Of these, an alicyclic group derived from norbornane, tricyclodecane, tetracyclododecane, adamantane, cyclopentane, or cyclohexane, a group in which such an alicyclic ring is substituted with any one of the above alkyl groups, and the like are preferable.

As examples of derivatives of the monovalent alicyclic hydrocarbon groups having 4 to 20 carbon atoms represented by R² in the general formula (1), groups having at least one substituent such as a hydroxyl group; a carboxyl group; an oxo group (=O); hydroxyalkyl groups having 1 to 4 carbon atoms such as a hydroxymethyl group, a 1-hydroxyethyl group, a 2-hydroxyethyl group, a 1-hydroxypropyl group, a 2-hydroxypropyl group, a 3-hydroxypropyl group, a 1-hydroxybutyl group, a 2-hydroxybutyl group, a 3-hydroxybutyl group, and a 4-hydroxybutyl group; alkoxy groups having 1 to 4 carbon atoms such as a methoxy group, an ethoxy group, an n-propoxy group, an i-propoxy group, an n-butoxy group, a 2-methylpropoxy group, a 1-methylpropoxy group, and a t-butoxy group; a cyano group; and cyanoalkyl groups having 2 to 5 carbon atoms such as a cyanomethyl group, a 2-cyanoethyl group, a 3-cyanopropyl group, and a 4-cyanobutyl group can be given. Of these substituents, the hydroxyl group, a carboxyl group, a hydroxymethyl group, a cyano group, and a cyanomethyl group are preferable.

As specific examples of the linear or branched alkyl group having 1 to 4 carbon atoms represented by R² in the general formula (1), a methyl group, an ethyl group, an n-propyl group, an i-propyl group, an n-butyl group, a 2-methylpropyl group, a 1-methylpropyl group, and a t-butyl group can be given. Among these, the methyl group and ethyl group are preferable.

As specific examples the group shown by "-C(R²)₃" in the formula (1), groups shown by the following general formulas (1a) to (1f) can be given.

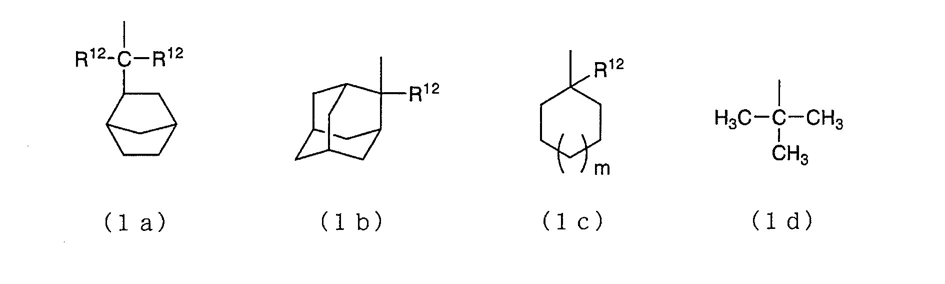

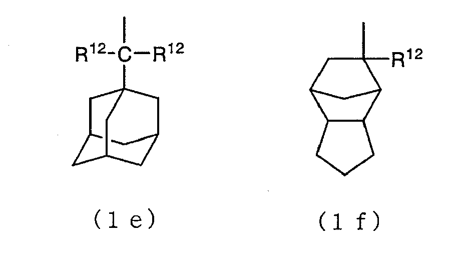

wherein R¹² individually represents a linear or branched alkyl group having 1 to 4 carbon atoms, and m is 0 or 1. As specific examples of the linear or branched alkyl group having 1 to 4 carbon atoms, a methyl group, an ethyl group, an n-propyl group, an i-propyl group, an n-butyl group, a 2-methylpropyl group, a 1-methylpropyl group, a t-butyl group, and the like can be given. Among these, the methyl group and the ethyl group are preferable.

The "-COOC(R²)₃" in the general formula (1) dissociates by the action of an acid and forms a carboxyl group to become an alkali-soluble part. The term "alkali-soluble part" refers to an (alkali-soluble) group which becomes anion by the action of an alkali. The term "acid-dissociable group" refers to a group in which the alkali-soluble part is protected by a blocking group and is not alkali-soluble until the blocking group is dissociated by an acid.

The resin for the resist agent is insoluble or scarcely soluble in alkali by itself, but becomes alkali-soluble by the action of an acid. The term "insoluble or scarcely soluble in alkali" refers to the properties of a resin of which 50% of the initial thickness of the film is left, when the film consisting only of the resin containing the repeating unit shown by the general formula (1) is processed (without being exposed to radiation) under the same developing conditions for forming a resist pattern using the resist layer containing a resin having the repeating unit shown by the general formula (1). The term "soluble in alkali" means the properties of a resin of which the film loses 50% or more of its initial thickness when processed in the same manner as above.

The polystyrene-reduced weight average molecular weight (Mw) of the resin for the resist agent determined by gel permeation chromatography (GPC) is usually 1000 to 500,000, preferably 1,000 to 100,000, and more preferably 1,000 to 50,000. If the Mw is below 1,000, the heat resistance of the formed resist pattern tends to decrease. If the Mw is exceeding 500,000, developability tends to decrease. The ratio (Mw/Mn) of the Mw to the polystyrene-reduced number average molecular weight (Mn) determined by gel permeation chromatography (GPC) of the resin for the resist agent is preferably 1 to 5, and more preferably 1 to 3. The content of low molecular weight components containing monomers as the major component in the resin for the resist agent is preferably 0.1 mass% or less, on a solid basis, of the total amount of the resin. The proportion of the low molecular weight components may be measured by high performance liquid chromatography (HPLC), for example.

### (Preparation method of resin for the resist agent)

The resin for the resist agent is prepared by polymerizing the monomer components containing polymerizable unsaturated monomers corresponding to the desired repeating units in an appropriate solvent in the presence of a chain transfer agent, as required, using a radical polymerization initiator such as a hydroperoxide, a dialkyl peroxide, a diacyl peroxide, or an azo compound.

As examples of the solvent used for polymerization, alkanes such as n-pentane, n-hexane, n-heptane, n-octane, n-nonane, and n-decane; cycloalkanes such as cyclohexane, cycloheptane, cyclooctane, decalin, and norbornane; aromatic hydrocarbons such as benzene, toluene, xylene, ethylbenzene, and cumene; halogenated hydrocarbons such as chlorobutanes, bromohexanes, dichloroethanes, hexamethylene dibromide, and chlorobenzene; saturated carboxylic acid esters such as ethyl acetate, n-butyl acetate, i-butyl acetate, and methyl propionate; ethers such as tetrahydrofuran, dimethoxy ethanes, and diethoxy ethanes; alcohols such as methanol, ethanol, 1-propanol, 2- propanol, 1-butanol, 2-butanol, isobutanol, 1-pentanol, 3-pentanol, 4-methyl-2-pentanol, o-chlorophenol, and 2-(1-methylpropyl)phenol; and ketones such as acetone, 2-butanone, 3-methyl-2-butanone, 4-methyl-2-pentanone, 2-heptanone, cyclopentanone, cyclohexanone, and methylcyclohexanone can be given. These solvents may be used either individually or in combination of two or more.

The polymerization temperature is usually from 40 to 150°C, and preferably from 50 to 120°C. The reaction time is usually from 1 to 48 hours, and preferably from 1 to 24 hours. It is preferable that the resin for the resist agent contain almost no impurities such as halogens and metals. The smaller the amount of impurities, the better the sensitivity, resolution, process stability, and pattern profile. The resin for the resist agent may be purified by a chemical purification method (e.g., washing with water or liquid-liquid extraction) or a combination of the chemical purification method and a physical purification method (e.g., ultrafiltration or centrifugation), for example.

### (Acid generator)

The positive-tone resist agent used in the present invention preferably comprises an acid generator having a structure shown by the following general formula (6) which is decomposed by exposure to radiation,

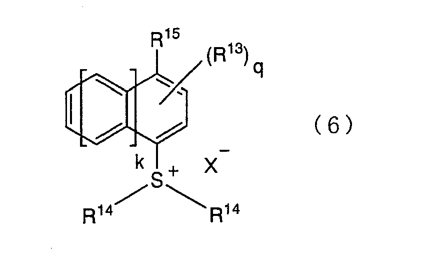

wherein R¹⁵ represents a hydrogen atom, a fluorine atom, a hydroxyl group, a linear or branched alkyl group having 1 to 10 carbon atoms, a linear or branched alkoxy group having 1 to 10 carbon atoms, or a linear or branched alkoxycarbonyl group having 2 to 11 carbon atoms, R¹³ represents a linear or branched alkyl group or alkoxy group having 1 to 10 carbon atoms or a linear, branched, or cyclic alkanesulfonyl group having 1 to 10 carbon atoms.

In the general formula (6), R¹⁴s may be individually a linear or branched alkyl group having 1 to 10 carbon atoms, a substituted or unsubstituted phenyl group, or a substituted or unsubstituted naphthyl group, or the R¹⁴s may bond together to form a divalent group having 2 to 10 carbon atoms which may be either substituted or unsubstituted, k is an integer of 0 to 2, X⁻ indicates an anion of the formula R¹⁶CₙF₂ₙSO₃⁻ (wherein R¹⁶ is a fluorine atom or a substituted or unsubstituted hydrocarbon group having 1 to 12 carbon atoms, and n is an integer of 1 to 10), and q is an integer of 0 to 10.

As examples of the linear or the branched alkyl group having 1 to 10 carbon atoms represented by R¹³, R¹⁴, or R¹⁵ in the general formula (6), a methyl group, an ethyl group, an n-propyl group, an i-propyl group, an n-butyl group, a 2-methylpropyl group, a 1-methylpropyl group, a t-butyl group, an n-pentyl group, an neopentyl group, an n-hexyl group, an n-heptyl group, an n-octyl group, a 2-ethylhexyl group, an n-nonyl group, and an n-decyl group can be given. Of these a methyl group, an ethyl group, an n-butyl group, a t-butyl group, and the like are preferable.

Examples of the linear or branched alkoxy group having 1 to 10 carbon atoms represented by R¹³ and R¹⁴ include a methoxy group, an ethoxy group, an n-propoxy group, an i-propoxy group, an n-butoxy group, a 2-methylpropoxy group, a 1-methylpropoxy group, a t-butoxy group, an n-pentyloxy group, a neopentyloxy group, an n-hexyloxy group, an n-heptyloxy group, an n-octyloxy group, a 2-ethylhexyloxy group, an n-nonyloxy group, and an n-decyloxy group. Of these, a methoxy group, an ethoxy group, an n-propoxy group, and an n-butoxy group are preferable.

Examples of the linear or branched alkoxycarbonyl group having 2 to 11 carbon atoms represented by R¹⁵ in the general formula (6) include a methoxycarbonyl group, an ethoxycarbonyl group, an n-propoxycarbonyl group, an i-propoxycarbonyl group, an n-butoxycarbonyl group, a 2-methylpropoxycarbonyl group, a 1-methylpropoxycarbonyl group, a t-butoxycarbonyl group, an n-pentyloxycarbonyl group, an neopentyloxycarbonyl group, an n-hexyloxycarbonyl group, an n-heptyloxycarbonyl group, an n-octyloxycarbonyl group, a 2-ethylhexyloxycarbonyl group, an n-nonyloxycarbonyl group, and an n-decyloxycarbonyl group. Of these, a methoxycarbonyl group, an ethoxycarbonyl group, an n-butoxycarbonyl group, and the like are preferable.

As examples of the linear, branched, or cyclic alkanesulfonyl group having 1 to 10 carbon atoms represented by R¹³ in the general formula (6), a methanesulfonyl group, an ethanesulfonyl group, an n-propanesulfonyl group, an n-buthanesulfonyl group, a tert-butanesulfonyl group, an n-pentanesulfonyl group, a neopentanesulfonyl group, an n-hexanesulfonyl group, an n-heptanesulfonyl group, an n-octanesulfonyl group, a 2-ethylhexanesulfonyl group, an n-nonanesulfonyl group, an n-decanesulfonyl group, a cyclopentanesulfonyl group, and a cyclohexanesulfonyl group can be given. Of these, a methanesulfonyl group, an ethanesulfonyl group, an n-propanesulfonyl group, an n-butanesulfonyl group, a cyclopentanesulfonyl group, and a cyclohexanesulfonyl group are preferable. q is preferably 1 to 2.

Examples of the substituted or unsubstituted phenyl group represented by R¹⁴ in the general formula (6) include a phenyl group, phenyl groups substituted with a linear, branched, or cyclic alkyl group having 1 to 10 carbon atoms such as an o-tolyl group, an m-tolyl group, a p-tolyl group, a 2,3-dimethylphenyl group, a 2,4-dimethylphenyl group, a 2,5-dimethylphenyl group, a 2,6-dimethylphenyl group, a 3,4-dimethylphenyl group, a 3,5-dimethylphenyl group, a 2,4,6-trimethylphenyl group, a 4-ethylphenyl group, a 4-t-butylphenyl group, 4-cyclohexylphenyl group, and a 4-fluorophenyl group; and groups obtained by substituting the phenyl groups or alkyl-substituted phenyl groups with one or more groups such as a hydroxyl group, a carboxyl group, a cyano group, a nitro group, an alkoxy group, an alkoxyalkyl group, an alkoxycarbonyl group, and an alkoxycarbonyloxy group.
Examples of the alkoxy group as the substituent for the phenyl group or alkyl-substituted phenyl group include linear, branched, or cyclic alkoxy groups having 1 to 20 carbon atoms such as a methoxy group, an ethoxy group, an n-propoxy group, an i-propoxy group, an n-butoxy group, a 2-methylpropoxy group, a 1-methylpropoxy group, a t-butoxy group, a cyclopentyloxy group, and a cyclohexyloxy group.

Examples of the alkoxyalkyl group include linear, branched, or cyclic alkoxyalkyl groups having 2 to 21 carbon atoms such as a methoxymethyl group, an ethoxymethyl group, a 1-methoxyethyl group, a 2-methoxyethyl group, a 1-ethoxyethyl group, and a 2-ethoxyethyl group. Examples of the alkoxycarbonyl group include linear, branched, or cyclic alkoxycarbonyl groups having 2 to 21 carbon atoms such as a methoxycarbonyl group, an ethoxycarbonyl group, an n-propoxycarbonyl group, an i-propoxycarbonyl group, an n-butoxycarbonyl group, a 2-methylpropoxycarbonyl group, a 1-methylpropoxycarbonyl group, a t-butoxycarbonyl group, a cyclopentyloxycarbonyl group, and a cyclohexyloxycarbonyl group.

Examples of the alkoxycarbonyloxy group include linear, branched, or cyclic alkoxycarbonyloxy groups having 2 to 21 carbon atoms such as a methoxycarbonyloxy group, an ethoxycarbonyloxy group, an n-propoxycarbonyloxy group, an i-propoxycarbonyloxy group, an n-butoxycarbonyloxy group, a t-butoxycarbonyloxy group, a cyclopentyloxycarbonyl group, and a cyclohexyloxycarbonyl group. Preferable phenyl groups which may have a substituent represented by R¹⁴ in the general formula (6) are a phenyl group, a 4-cyclohexylphenyl group, a 4-t-butylphenyl group, a 4-methoxyphenyl group, a 4-t-butoxyphenyl group, and the like.

Examples of the substituted or unsubstituted naphthyl group represented by R¹⁴ in the general formula (6) include naphthyl groups substituted or unsubstituted with a linear, branched, or cyclic alkyl group having 1 to 10 carbon atoms such as a 1-naphthyl group, a 2-methyl-1-naphthyl group, a 3-methyl-1-naphthyl group, a 4-methyl-1-naphthyl group, a 5-methyl-1-naphthyl group, a 6-methyl-1-naphthyl group, a 7-methyl-1-naphthyl group, a 8-methyl-1-naphthyl group, a 2,3-dimethyl-1-naphthyl group, a 2,4-dimethyl-1-naphthyl group, a 2,5-dimethyl-1-naphthyl group, a 2,6-dimethyl-1-naphthyl group, a 2,7-dimethyl-1-naphthyl group, a 2,8-dimethyl-1-naphthyl group, a 3,4-dimethyl-1-naphthyl group, a 3,5-dimethyl-1-naphthyl group, a 3,6-dimethyl-1-naphthyl group, a 3,7-dimethyl-1-naphthyl group, a 3,8-dimethyl-1-naphthyl group, a 4,5-dimethyl-1-naphthyl group, a 5,8-dimethyl-1-naphthyl group, a 4-ethyl-1-naphthyl group, a 2-naphthyl group, a 1-methyl-2-naphthyl group, a 3-methyl-2-naphthyl group, and a 4-methyl-2-naphthyl group; and groups obtained by further substituting one or more hydrogen atoms in the naphthyl group or alkyl-substituted naphthyl group with a hydroxyl group, a carboxyl group, a cyano group, a nitro group, an alkoxy group, an alkoxyalkyl group, an alkoxycarbonyl group, or an alkoxycarbonyloxy group. As specific examples of the alkoxy group, alkoxyalkyl group, alkoxycarbonyl group, and alkoxycarbonyloxy group which are the substituents, the groups illustrated for the phenyl group and the alkyl-substituted phenyl groups can be given.

As the naphtyl group which may have a substituent represented by R¹⁴ in the general formula (6), a 1-naphthyl group, a 1-(4-methoxynaphthyl) group, a 1-(4-ethoxynaphthyl) group, a 1-(4-n-propoxynaphtyl) group, a 1-(4-n-butoxynaphthyl) group, a 2-(7-methoxynaphtyl) group, a 2-(7-ethoxynaphtyl) group, a 2-(7-n-propoxynaphtyl) group, a 2-(7-n-butoxynaphtyl) group, and the like can be given.

As an example of the divalent group having 2 to 10 carbon atoms formed by two R¹⁴ groups in the general formula (6), a group forming a 5 or 6 member ring together with the sulfur atom in the general formula (6), preferably a 5 member ring (i.e. tetrahydrothiophene ring) is preferable.
As examples of the substituent for the above divalent groups, the groups previously mentioned for the phenyl group and alkyl-substituted phenyl groups, such as a hydroxyl group, a carboxyl group, a cyano group, a nitro group, an alkoxy group, an alkoxyalkyl group, an alkoxycarbonyl group, and an alkoxycarbonyloxy group can be given. As the group R¹⁴ in the general formula (6), a methyl group, an ethyl group, a phenyl group, a 4-methoxyphenyl group, and a 1-naphthyl group, and a divalent group having a tetrahydrothiophene cyclic structure formed by two R¹⁴ groups together with the sulfur atom, and the like are preferable.

As examples of a preferable cation moiety in the general formula (6), a triphenylsulfonium cation, a tri-1-naphthylsulfonium cation, tri-tert-butylphenylsulfonium cation, a 4-fluorophenyl-diphenylsulfonium cation, a di-4-fluorophenyl-phenylsulfonium cation, a tri-4-fluorophenylsulfonium cation, a 4-cyclohexylphenyl-diphenylsulfonium cation, a 4-methanesulfonylphenyl-diphenylsulfonium cation, a 4-cyclohexanesulfonyl-diphenylsulfonium cation, a 1-naphthyldimethylsulfonium cation, a 1-naphthyldiethylsulfonium cation, a 1-(4-hydroxynaphthyl)dimethylsulfonium cation, a 1-(4-methylnaphthyl)dimethylsulfonium cation, a 1-(4-methylnaphthyl)diethylsulfonium cation, a 1-(4-cyanonaphthyl)dimethylsulfonium cation, a 1-(4-cyanonaphthyl)diethylsulfonium cation, a 1-(3,5-dimethyl-4-hydroxyphenyl)tetrahydrothiophenium cation, a 1-(4-methoxynaphthyl)tetrahydrothiophenium cation, a 1-(4-ethoxynaphthyl)tetrahydrothiophenium cation, a 1-(4-n-propoxynaphthyl)tetrahydrothiophenium cation, a 1-(4-n-butoxynaphthyl)tetrahydrothiophenium cation, a 2-(7-methoxy naphthyl)tetrahydrothiophenium cation, a 2-(7-ethoxynaphthyl)tetrahydrothiophenium cation, a 2-(7-n-propoxynaphthyl)tetrahydrothiophenium cation, a 2-(7-n-butoxynaphthyl)tetrahydrothiophenium cation, and the like can be given.

The "CₙF₂ₙ-" group in the anion (R¹⁶CₙF₂ₙSO³⁻) represented by X⁻ in the general formula (6) is a perfluoroalkylene group having carbon atoms of the number n. This perfluoroalkylene group may be either linear or branched. n is preferably 1, 2, 4, or 8. As a hydrocarbon group having 1 to 12 carbon atoms which may have a substituent represented by R¹⁶, an alkyl group having 1 to 12 carbon atoms, a cycloalkyl group, or a bridge alicyclic hydrocarbon group are preferable. As specific examples, a methyl group, an ethyl group, an n-propyl group, an i-propyl group, an n-butyl group, a 2-methylpropyl group, a 1-methylpropyl group, a t-butyl group, an n-pentyl group, an neopentyl group, an n-hexyl group, a cyclohexyl group, an n-heptyl group, an n-octyl group, a 2-ethylhexyl group, an n-nonyl group, an n-decyl group, a norbornyl group, a norbornylmethyl group, a hydroxynorbornyl group, and an adamantyl group can be given.

As examples of a preferable anion moiety in the general formula (6), a trifluoromethanesulfonate anion, a perfluoro-n-butanesulfonate anion, a perfluoro-n-octanesulfonate anion, a 2-bicyclo[2.2.1]hept-2-yl-1,1,2,2-tetrafluoroethanesulfonate anion, a 2-bicyclo[2.2.1]hept-2-yl-1,1-difluoroethanesulfonate anion, and the like can be given.

The acid generators may be used either individually or in combination of two or more. Acid generators other than the above-mentioned acid generators (hereinafter referred to as "other acid generators") can also be used. As examples of the "other acid generators", onium salts, halogen-containing compounds, diazoketone compounds, sulfone compounds, and sulfonate compounds can be given.

As examples of the onium salt compound, iodonium salt, sulfonium salt, phosphonium salt, diazonium salt, pyridinium salt, and the like can be given. As specific examples of the onium salt compounds, diphenyliodonium trifluoromethanesulfonate, diphenyliodonium nonafluoro-n-butanesulfonate, diphenyliodonium perfluoro-n-octanesulfonate, diphenyliodonium 2-bicyclo[2.2.1]hept-2-yl-1,1,2,2-tetrafluoroethanesulfonate, bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, cyclohexyl-2-oxocyclohexyl-methylsulfonium trifluoromethanesulfonate, dicyclohexyl-2-oxocyclohexylsulfonium trifluoromethanesulfonate, 2-oxocyclohexyldimethylsulfonium trifluoromethanesulfonate, and the like can be given.

As examples of halogen-containing compounds, haloalkyl group-containing hydrocarbon compounds, haloalkyl group-containing heterocyclic compounds, and the like can be given. As specific examples of the halogen-containing compound, (trichloromethyl)-s-triazine derivatives such as phenylbis(trichloromethyl)-s-triazine, 4-methoxyphenylbis(trichloromethyl)-s-triazine, 1-naphthylbis(trichloromethyl)-s-triazine, and 1,1-bis(4-chlorophenyl)-2,2,2-trichloroethane can be given.

As examples of the diazoketone compound, 1,3-diketo-2-diazo compounds, diazobenzoquinone compounds, diazonaphthoquinone compounds, and the like can be given. As specific examples of the diazoketone compound, 1,2-naphthoquinonediazido-4-sulfonyl chloride, 1,2-naphthoquinonediazido-5-sulfonyl chloride, 1,2-naphthoquinonediazido-4-sulfonate or 1,2-naphthoquinonediazido-5-sulfonate of 2,3,4,4'-tetrahydroxybenzophenone, and 1,2-naphthoquinonediazido-4-sulfonate or 1,2-naphthoquinonediazido-5-sulfonate of 1,1,1-tris(4-hydroxyphenyl)ethane can be given.

As examples of the sulfone compound, β-ketosulfone, β-sulfonylsulfone, α-diazo compounds of these compounds, and the like can be given. As specific examples of the sulfone compound, 4-trisphenacylsulfone, mesitylphenacylsulfone, bis(phenylsulfonyl)methane, and the like can be given.

As examples of the sulfonate compound, alkyl sulfonate, alkylimide sulfonate, haloalkyl sulfonate, aryl sulfonate, imino sulfonate, and the like can be given. As specific examples of the sulfone compounds, benzointosylate, tris(trifluoromethanesulfonate) of pyrogallol, nitrobenzyl-9,10-diethoxyanthracene-2-sulfonate, trifluoromethanesulfonylbicyclo[2.2.1]hept-5-ene-2,3-dicarbodiimide, nonafluoro-n-butanesulfonylbicyclo[2.2.1]hept-5-ene-2,3-dicarbodiimide, perfluoro-n-octanesulfonylbicyclo[2.2.1]hept-5-ene-2,3-dicarbodiimide, 2-bicyclo[2.2.1]hept-2-yl-1,1,2,2-tetrafluoroethanesulfonylbicyclo[2.2.1]hept-5-ene-2,3-dicarbodiimide, N-(trifluoromethanesulfonyloxy)succinimide, N-(nonafluoro-n-butanesulfonyloxy)succinimide, N-(perfluoro-n-octanesulfonyloxy)succinimide, N-(2-bicyclo[2.2.1]hept-2-yl-1,1,2,2-tetrafluoroethanesulfonyloxy)succinimide, 1,8-naphthalenedicarboxylic acid imide trifluoromethanesulfonate, 1,8-naphthalenedicarboxylic acid imide nonafluoro-n-butanesulfonate, 1,8-naphthalenedicarboxylic acid imide perfluoro-n-octanesulfonate, and the like can be given.

Among these "other acid generators", diphenyliodonium trifluoromethanesulfonate, diphenyliodonium nonafluoro-n-butanesulfonate, diphenyliodonium perfluoro-n-octanesulfonate, diphenyliodonium 2-bicyclo[2.2.1]hept-2-yl-1,1,2,2-tetrafluoroethanesulfonate, bis(4-t-butylphenyl)iodonium trifluoromethanesulfonate, bis(4-t-butylphenyl)iodonium nonafluoro-n-butanesulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, cyclohexyl-2-oxocyclohexyl-methylsulfonium trifluoromethanesulfonate, dicyclohexyl-2-oxocyclohexylsulfonium trifluoromethanesulfonate, 2-oxocyclohexyldimethylsulfonium trifluoromethanesulfonate, trifluoromethanesulfonylbicyclo[2.2.1]hept-5-ene-2,3-dicarbodiimide, nonafluoro-n-butanesulfonylbicyclo[2.2.1]hept-5-ene-2,3-dicarbodiimide, perfluoro-n-octanesulfonylbicyclo[2.2.1]hept-5-ene-2,3-dicarbodiimide, 2-bicyclo[2.2.1]hept-2-yl-1,1,2,2-tetrafluoroethanesulfonylbicyclo[2.2.1]hept-5-ene-2,3-dicarbodiimide, N-(trifluoromethanesulfonyloxy)succinimide, N-(nonafluoro-n-butanesulfonyloxy)succinimide, N-(perfluoro-n-octanesulfonyloxy)succinimide, N-(2-bicyclo[2.2.1]hept-2-yl-1,1,2,2-tetrafluoroethanesulfonyloxy)succinimide, 1,8-naphthalenedicarboxylic acid imide trifluoromethanesulfonate, and the like are preferable. These other acid generators may be used either individually or in combination of two or more.

Combined use of the acid generator having the structure of the general formula (6) with the "other acid generators" is also preferable. When the "other acid generators" are used, the proportion of the "other acid generators" is usually 80 mass% or less, and preferably 60 mass% or less of the total amount of the acid generators and the "other acid generators".

The total amount of the acid generators contained in the positive-tone resist agent is preferably 0.1 to 20 parts by mass, and more preferably 0.5 to 10 parts by mass for 100 parts by mass of the resin for the resist agent from the viewpoint of ensuring sensitivity and developability as the resist. If this total amount is below 0.1 part by mass, sensitivity and developability of the positive-tone resist agent tend to decrease. If this total amount is exceeding 20 parts by mass, the transparency of the resist to radiation tends to decrease, which makes it difficult to obtain a rectangular resist pattern.

### (Acid diffusion controller)

It is preferable that the positive-tone resist agent used in the present invention contain an acid diffusion controller. The acid diffusion controller controls diffusion of the acid generated from the acid generator upon exposure in the resist layer and hinders undesired chemical reactions in the unexposed area. The addition of the acid diffusion controller improves storage stability of the resist agent and resolution as a resist. Moreover, the addition of the acid diffusion controller prevents the line width of the resist pattern from changing due to variation of post-exposure delay (PED) which is a period of time from exposure to post-exposure heat treatment, whereby a resist agent with remarkably superior process stability can be obtained. A nitrogen-containing organic compound and a photodisintegrating base are preferably used as an acid diffusion controller. The photodisintegrating base is an onium salt compound which exhibits an acid diffusion controlling effect by decomposing upon exposure to radiation.

### (Nitrogen-containing organic compound)

As examples of the nitrogen-containing organic compound, compounds shown by the following general formula (7) (hereinafter referred to from time to time as "nitrogen-containing compounds (I)"), compounds having two nitrogen atoms in the molecule (hereinafter referred to from time to time as "nitrogen-containing compounds (II)"), polyamino compounds or polymers having three or more nitrogen atoms (hereinafter collectively referred to from time to time as "nitrogen-containing compounds (III)"), amide group-containing compounds, urea compounds, nitrogen-containing heterocyclic compounds, and the like can be given.

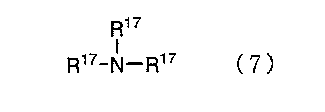

wherein R¹⁷ individually represents a hydrogen atom, a substituted or unsubstituted, linear, branched, or cyclic alkyl group, a substituted or unsubstituted aryl group, or a substituted or unsubstituted aralkyl group.

As examples of the nitrogen-containing compound (I), mono(cyclo)alkylamines such as n-hexylamine, n-heptylamine, n-octylamine, n-nonylamine, n-decylamine, and cyclohexylamine; di(cyclo)alkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; tri(cyclo)alkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, methyldicyclohexylamine, and tricyclohexylamine; and substitute alkylamines such as 2,2',2"-nitrotriethanol; aromatic amines such as aniline, N-methylaniline, N,N-dimethylaniline, 2-methylaniline, 3-methylaniline, 4-methylaniline, 4-nitroaniline, diphenylamine, triphenylamine, naphthylamine, 2,4,6-tri-tert-butyl-N-methylaniline, N-phenyldiethanolamine, and 2,6-diisopropylaniline are preferable.

Examples of preferable nitrogen-containing compounds (II) include ethylenediamine, N,N,N',N'-tetramethylethylenediamine, tetramethylenediamine, hexamethylenediamine, 4,4'-diaminodiphenylmethane, 4,4'-diamino diphenyl ether, 4,4'-diaminobenzophenone, 4,4'-diaminodiphenylamine, 2,2'-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, 1,3-bis[1-(4-aminophenyl)-1-methylethyl]benzene, bis(2-dimethylaminoethyl)ether, bis(2-diethylaminoethyl) ether, 1-(2-hydroxyethyl)-2-imidazolizinone, 2-quinoxalinol, N,N,N',N'-tetrakis(2-hydroxypropyl)ethylenediamine, and N,N,N',N",N"-pentamethyldiethylenetriamine.

As examples of the nitrogen-containing compound (III), polyethyleneimine, polyallylamine, and a polymer of 2-dimethylaminoethylacrylamide can be given.

As examples of preferable amide group-containing compounds, N-t-butoxycarbonyl group-containing amino compounds such as N-t-butoxycarbonyl di-n-octylamine, N-t-butoxycarbonyl di-n-nonylamine, N-t-butoxycarbonyl di-n-decylamine, N-t-butoxycarbonyl dicyclohexylamine, N-t-butoxycarbonyl-1-adamantylamine, N-t-butoxycarbonyl-2-adamantylamine, N-t-butoxycarbonyl-N-methyl-1-adamantylamine, (S)-(-)-1-(t-butoxycarbonyl)-2-pyrrolidine methanol, (R)-(+)-1-(t-butoxycarbonyl)-2-pyrrolidine methanol, N-t-butoxycarbonyl-4-hydroxypiperidine, N-t-butoxycarbonylpyrrolidine, N-t-butoxycarbonylpiperazine, N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N-di-t-butoxycarbonylhexamethylenediamine, N,N,N'N'-tetra-t-butoxycarbonylhexamethylenediamine, N,N'-di-t-butoxycarbonyl-1,7-diaminoheptane, N,N'-di-t-butoxycarbonyl-1,8-diaminonooctane, N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-diaminodiphenylmethane, N-t-butoxycarbonylbenzimidazole, N-t-butoxycarbonyl-2-methylbenzimidazole, N-t-butoxycarbonyl-2-phenylbenzimidazole, and N-t-butoxycarbonylpyrrolidine; formamide, N-methylformamide, N,N-dimethylformamide, acetamide, N-methylacetamide, N,N-dimethylacetamide, propionamide, benzamide, pyrrolidone, N-methylpyrrolidone, N-acetyl-1-adamantylamine, tris(2-hydroxyethyl)isocyanuric acid, and the like can be given.

As examples of preferable urea compounds, urea, methylurea, 1,1-dimethylurea, 1,3-dimethylurea, 1,1,3,3-tetramethylurea, 1,3-diphenylurea, and tri-n-butylthiourea can be given. Examples of preferable nitrogen-containing heterocyclic compounds include: imidazoles such as imidazole, 4-methylimidazole, 4-methyl-2-phenylimidazole, benzimidazole, 2-phenylbenzimidazole, 1-benzyl-2-methylimidazole, and 1-benzyl-2-methyl-1H-imidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, acridine, and 2,2':6',2"-terpyridine; piperazines such as piperazine and 1-(2-hydroxyethyl)piperazine; and pyrazine, pyrazole, pyridazine, quinoxaline, purine, pyrrolidine, piperidine, piperidineethanol, 3-piperidino-1,2-propanediol, morpholine, 4-methylmorpholine, 1-(4-morpholinyl)ethanol, 4-acetylmorpholine, 3-(N-morpholino)-1,2-propanediol, 1,4-dimethylpiperazine, and 1,4-diazabicyclo[2.2.2]octane.

### (Photodisintegrating base)

The photodisintegrating base is an onium salt compound which generates a base exhibiting an acid diffusion controlling effect by decomposing upon exposure to radiation. As specific examples of the onium salt compound, the sulfonium salt compound shown by the following general formula (8) and the iodonium compound shown by the following general formula (9) can be given,

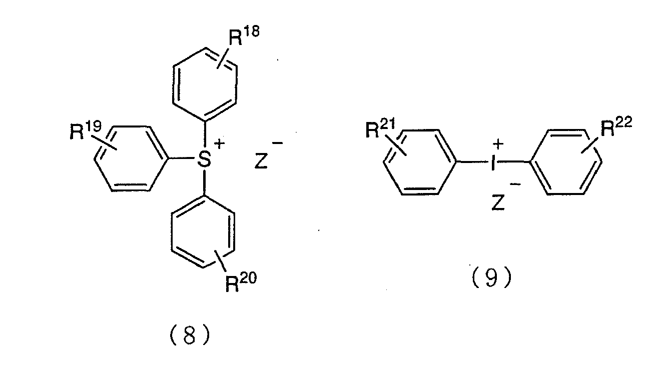

wherein R¹⁸ to R²² individually represent a hydrogen atom, an alkyl group, an alkoxy group, a hydroxyl group, or a halogen atom, and Z⁻ represents -OH⁻, RCOO⁻, RSO₃⁻ (wherein R represents an alkyl group, an aryl group, or an alkaryl group), or a group shown by an anion shown in formula (10).

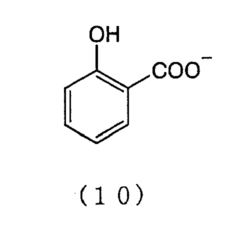

Specific examples of the sulfonium salt compound and iodonium salt compound include triphenylsulfonium hydroxide, triphenylsulfonium acetate, triphenylsulfonium salicylate, diphenyl-4-hydroxyphenylsulfonium hydroxide, diphenyl-4-hydroxyphenylsulfonium acetate, diphenyl-4-hydroxyphenylsulfonium salicylate, bis(4-t-butylphenyl)iodonium hydroxide, bis(4-t-butylphenyl)iodonium acetate, bis(4-t-butylphenyl)iodonium hydroxide, bis(4-t-butylphenyl)iodonium acetate, bis(4-t-butylphenyl)iodonium salicylate, 4-t-butylphenyl-4-hydroxyphenyliodonium hydroxide, 4-t-butylphenyl-4-hydroxyphenyliodonium acetate, 4-t-butylphenyl-4-hydroxyphenyliodonium salicylate, bis(4-t-butylphenyl)iodonium 10-camphorsulfonate, diphenyliodonium 10-camphorsulfonate, triphenylsulfonium 10-camphorsulfonate, and 4-t-butoxyphenyl-diphenylsulfonium 10-camphorsulfonate.

These acid diffusion controllers may be used either individually or in combination of two or more. The amount of the acid diffusion controller to be added is usually 15 parts by mass or less, preferably 10 parts by mass or less, and more preferably 5 parts by mass or less for 100 parts by mass of the resin for the resist agent. If the amount of the acid diffusion controller exceeds 15 parts by mass, sensitivity as the resist agent tends to decrease. If the amount of the acid diffusion controller is below 0.001 parts by mass, the resist pattern shape or dimensional accuracy may be decreased depending on the process conditions.

### (Solvent)

It is desirable that the positive-tone resist agent used in the present invention comprises the resin for the resist agent, the acid generator, the acid diffusion controller, and the like dissolved in a solvent. As the solvent, at least one solvent selected from the group consisting of propylene glycol mono-methyl ether acetate, 2-heptanone, and cyclohexanone (hereinafter referred to from time to time as "solvent (1)") is preferable. Solvents other than the solvent (1) (hereinafter referred to from time to time as "other solvents") can also be used. The solvent (1) and the other solvents may be used in combination.

As the other solvents, propylene glycol monoalkyl ether acetates such as propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, and 2-octanone;

cyclic ketones such as cyclopentanone, 3-methylcyclopentanone, 2-methylcyclohexanone, 2,6-dimethylcyclohexanone, isophorone; alkyl 3-alkoxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate;

n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, ethyl 2-hydroxy-2-methyl propionate, ethoxyethyl acetate, ethyl hydroxyacetate, methyl 2-hydroxy-3-methylbutyrate, 3-methoxybutylacetate, 3-methyl-3-methoxybutylacetate, 3-methyl-3-methoxybutylpropionate, 3-methyl-3-methoxybutylbutyrate, ethyl acetate, n-propyl acetate, n-butyl acetate, methyl acetoacetate, ethyl acetoacetate, methyl pyruvate, ethyl pyruvate, N-methyl pyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, and propylene carbonate can be given.

Among these solvents, linear or branched ketones, cyclic ketones, propylene glycol monoalkyl ether acetates, alkyl 2-hydroxypropionates, alkyl 3-alkoxypropionates, γ-butyrolactone, and the like are preferable. These solvents may be used either individually or in combination of two or more.

When the solvent (1) is used together with the other solvents, the proportion of the other solvents is usually 50 mass% or less, preferably 30 mass% or less, and more preferably 25 mass% or less of the total amount of the solvents. The amount of the solvent included in the positive-tone resist agent in terms of the total solid content of the positive-tone resist agent is usually 2 to 70 mass%, preferably 4 to 25 mass%, and more preferably 4 to 10 mass%.

The positive-tone resist agent is prepared by homogeneously dissolving the components in a solvent so that the solid content reaches in the above-mentioned range and filtering through a filter with a pore diameter of about 0.02 µm, for example.

Various other additives such as surfactants, sensitizers, and aliphatic additives can be optionally added to the positive-tone resist agent.

The surfactant improves applicability, striation, developability, and the like. As the surfactants, nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, and polyethylene glycol distearate; commercially available products such as "KP341" (manufactured by Shin-Etsu Chemical Co., Ltd.), "Polyflow No. 75" and "Polyflow No. 95" (manufactured by Kyoeisha Chemical Co., Ltd.), "EFTOP EF301", "EFTOP EF303", and "EFTOP EF352" (manufactured by JEMCO, Inc.), "MEGAFAC F171" and "MEGAFAC F173" (manufactured by Dainippon Ink and Chemicals, Inc.), "Fluorad FC430" and "Fluorad FC431" (manufactured by Sumitomo 3M Ltd.), "Asahi Guard AG710", "Surflon S-382", "Surflon SC-101", "Surflon SC-102", "Surflon SC-103", "Surflon SC-104", "Surflon SC-105", and "Surflon SC-106" (manufactured by Asahi Glass Co., Ltd.), and the like can be given. These surfactants may be used either individually or in combination of two or more. The amount of the surfactants to be added is usually 2 parts by mass or less for 100 parts by mass of the hydroxy group-containing resin.

The sensitizers absorb radiation energy and transmit the energy to the acid generator, thereby increasing the amount of an acid generated upon exposure. The sensitizers improve apparent sensitivity of the resist agent. As examples of the sensitizer, carbazoles, acetophenones, benzophenones, naphthalenes, phenols, biacetyl, eosine, rose bengal, pyrenes, anthracenes, phenothiazines, and the like can be given. These sensitizers may be used either individually or in combination of two or more. Addition of a dye or a pigment makes a latent image visible in the exposed area, thereby decreasing the effects of halation during exposure. Use of an adhesion improver improves adhesion of the resist film to the substrates. The amount of the sensitizer to be added is usually 50 parts by mass or less for 100 parts by mass of the hydroxy group-containing resin.

As examples of the alicyclic additives that can be added to the positive-tone resist agent, alicyclic additives having an acid-dissociable group and alicyclic additives having no acid-dissociable group can be given. The alicyclic additives improve dry etching tolerance, pattern shape, and adhesion to substrate. As specific examples of such alicyclic additives, adamantane derivatives such as 1-adamantanecarboxylic acid, 2-adamantanone, t-butyl-1-adamantanecarboxylate, t-butoxycarbonylmethyl 1-adamantanecarboxylate, α-butyrolactone 1-adamantanecarboxylate, di-t-butyl 1,3-adamantanedicarboxylate, t-butyl 1-adamantaneacetate, t-butoxycarbonylmethyl 1-adamantaneacetate, di-t-butyl 1,3-adamantanediacetate, and 2,5-dimethyl-2,5-di(adamantylcarbonyloxy)hexane; deoxycholates such as t-butyl deoxycholate, t-butoxycarbonylmethyl deoxycholate, 2-ethoxyethyl deoxycholate, 2-cyclohexyloxyethyl deoxycholate, 3-oxocyclohexyl deoxycholate, tetrahydropyranyl deoxycholate, and mevalonolactone deoxycholate; lithocholates such as t-butyl lithocholate, t-butoxycarbonylmethyl lithocholate, 2-ethoxyethyl lithocholate, 2-cyclohexyloxyethyl lithocholate, 3-oxocyclohexyl lithocholate, tetrahydropyranyl lithocholate, and mevalonolactone lithocholate; alkyl carboxylates such as dimethyl adipate, diethyl adipate, dipropyl adipate, di-n-butyl adipate, and di-t-butyl adipate; 3-[2-hydroxy-2,2-bis(trifluoromethyl)ethyl]tetracyclo[4.4.0.12,5.17,10]dodecane and the like can be given.

These alicyclic additives may be used either individually or in combination of two or more. The amount of the alicyclic additives to be added is usually 50 parts by mass or less, and preferably 30 parts by mass or less for 100 parts by mass of the hydroxyl group-containing resin. If the amount of the alicyclic additives exceeds 50 parts by mass for 100 parts by mass of the hydroxyl group-containing resin, heat resistance as a resist tends to decrease. As other additives, low molecular weight alkali solubility controllers containing an alkali-soluble resin and/or acid dissociable protecting group, halation inhibitors, preservation stabilizers, antifoaming agents, and the like can be given.

### EXAMPLES

The present invention is described below in detail by way of examples. Note that the present invention is not limited to the following examples. In the examples, "part(s)" means "part(s) by mass" and "%" means "mass%" unless otherwise indicated. The methods of measuring and evaluating various properties were as follows.

[Mw and Mn]: Measured by gel permeation chromatography (GPC) using monodisperse polystyrene as a standard and using GPC columns (manufactured by Tosoh Corp., G2000HXL × 2, G3000HXL × 1, G4000HXL × 1) at a flow rate of 1.0 ml/minute, using tetrahydrofuran as an eluate, at a column temperature of 40°C. Dispersibility Mw/Mn was calculated from the measurement result of Mw and Mn.

[Residual rate of low-molecular components]: The amount of low-molecular components was measured by high performance liquid chromatography (HPLC) using "Intersil ODS-25 µm column" (4.6 mmϕ × 250 mm) manufactured by GL Sciences Inc., at a flow rate of 1.0 ml/min using an acrylonitrile/0.1% phosphoric acid aqueous solution as an eluate. The low-molecular components contain monomers as major components. More particularly, the low-molecular components comprise components having a molecular weight of below 1,000, and preferably less than that of trimers.

[¹³C-NMR analysis]: ¹³C-NMR analysis of each of the polymers was carried out using "JNM-EX270" (manufactured by JEOL Ltd.) and CDCl₃ as a solvent.

### (Synthetic Example 1: (Polymer (A-1))

53.93 g (50 mol%) of the compound shown by the following formula (m-1), 10.69 g (10 mol%) of the compound shown by the following formula (m-2), and 35.38 g (40 mol%) of the compound shown by the following formula (m-3) were dissolved in 200 g of 2-butanone. 5.58 g of dimethyl-2-2'-azobis(2-methylpropionate) was further added to prepare a monomer solution. A 1000 ml three-neck flask charged with 100 g of 2-butanone was purged with nitrogen and heated to 80°C with stirring, and the above monomer solution was added dropwise using a dripping funnel over three hours. The polymerization reaction was carried out for six hours after initiation of dripping. After completion of polymerization, the polymer solution was cooled with water to 30°C or lower and poured into 2000 g of methanol. A white precipitate produced was collected by filtration. The filtered white powder was washed twice with 400 g of methanol in the form of a slurry, filtered, and dried at 50°C for 17 hours to obtain a polymer (A-1) in the form of a white powder (74 g, yield of 74%). The Mw of the resulting polymer was 6900. As a result of ¹³C-NMR analysis, the resin was found to be a polymer containing the repeating units shown in the following formula (A-1) at a molar ratio of a/b/c = 53.0/9.8/37.2.

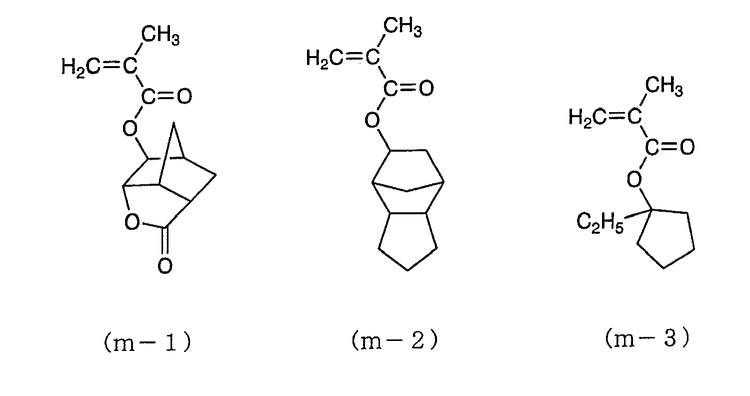

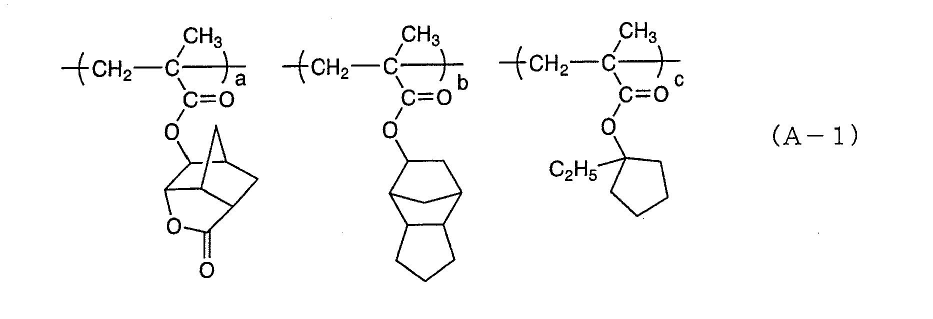

### <Polymer (A-1)>

Copolymerization ratio: a/b/c = 53.0/9.8/37.2, Mw/Mn = 1.70, Mw = 6900, amount of remaining low molecular components = 0.03 (mass%)

### (Synthetic Examples 2 to 8: (Polymers (A-1) to (A-8))

Experiments were carried out in the same manner as in the Synthetic Example 1, except for using different monomer combinations to obtain polymers (A-2) to (A-8), each having repeating units shown in the following formulas (A-2) to (A-8).

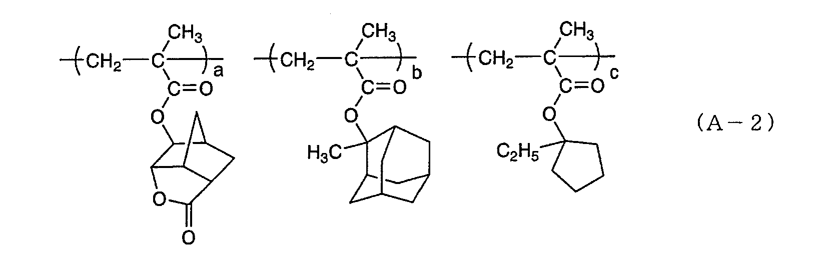

### <Polymer (A-2)>

Copolymerization ratio (mol ratio): a/b/c = 50/37/13, Mw/Mn = 1.62, Mw = 5200, amount of remaining low molecular components = 0.03 (mass%)

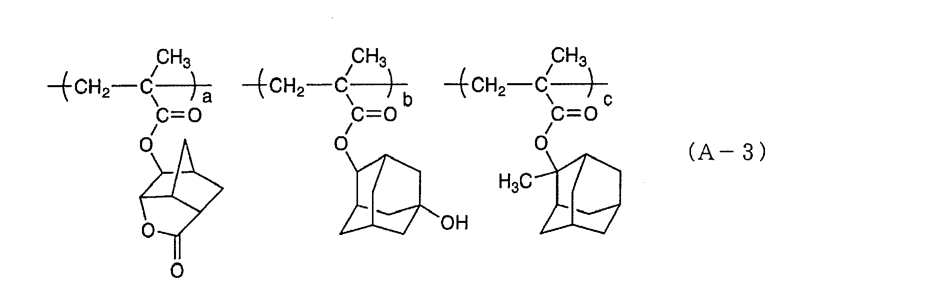

### <Polymer (A-3)>

Copolymerization ratio (mol ratio): a/b/c = 47.3/15.8/36.9, Mw/Mn = 1.60, Mw = 5000, amount of remaining low molecular components = 0.05 (mass%)

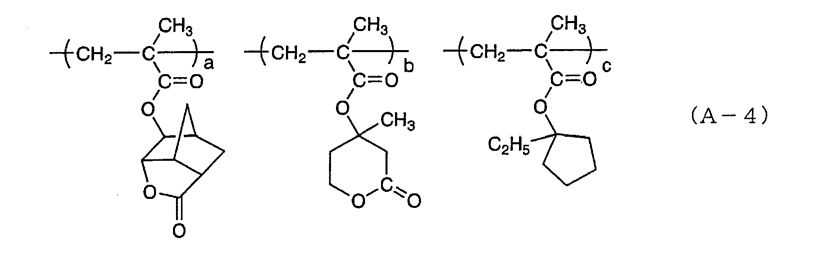

### <Polymer (A-4)>

Copolymerization ratio (mol ratio): a/b/c = 53.6/9.8/36.6, Mw/Mn = 69, Mw = 8100, amount of remaining low molecular components = 0.04 (mass%)

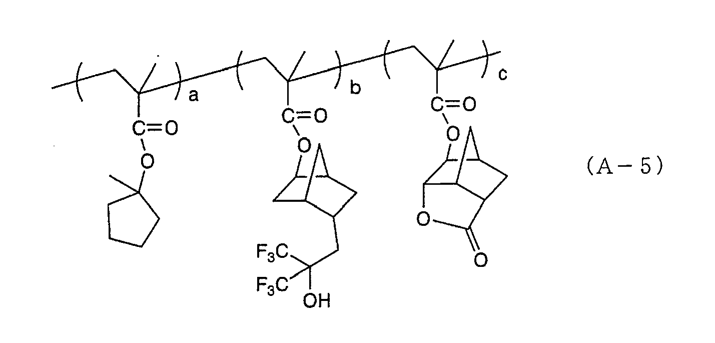

### <Polymer (A-5)>

Copolymerization ratio (mol ratio): a/b/c = 40.4/15.5/45.1, Mw/Mn = 1.73, Mw = 6100, amount of remaining low molecular components = 0.08 (mass%)

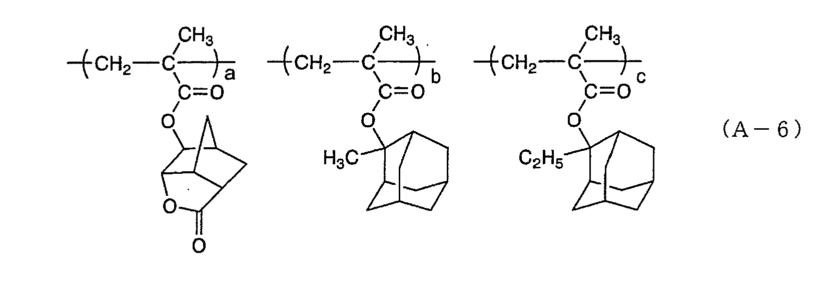

### <Polymer (A-6)>

Copolymerization ratio (mol ratio): a/b/c = 50.0/36.9/13.1, Mw/Mn = 1.78, Mw = 8200, amount of remaining low molecular components = 0.03 (mass%)

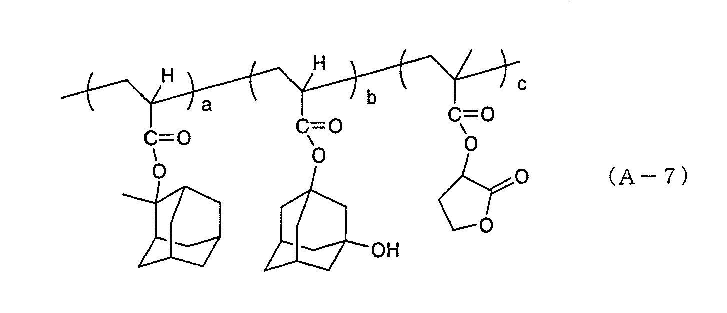

### <Polymer (A-7)>

Copolymerization ratio (mol ratio): a/b/c = 35.4/28.5/35.1, Mw/Mn = 1.93, Mw = 5900, amount of remaining low molecular components = 0.06 (mass%)

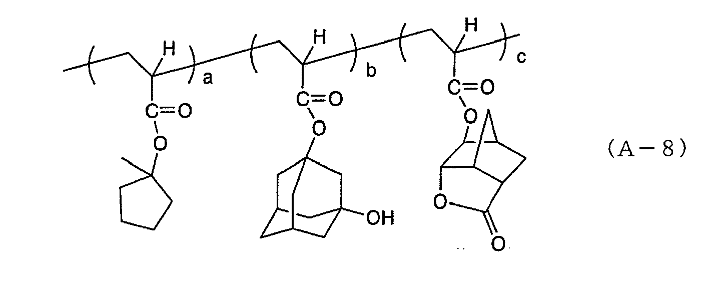

### <Polymer (A-8)>

Copolymerization ratio (mol ratio): a/b/c = 30.4/28.5/40.1, Mw/Mn = 1.93, Mw = 5500, amount of remaining low molecular components = 0.07 (mass%)

### (Preparation of positive-tone resist agent)

First resist agents (1) to (10) and second resist agents (11) to (15) were prepared using the synthesized polymers (A-1) to (A-8), the acid generators (D), acid diffusion controllers (E), and solvents (F) shown in Tables 1 and 2 at proportions shown in the Tables 1 and 2.

**TABLE 1**

| First resist agent | Polymer | | Acid generator | | Acid diffusion controller | | Solvent | |
|---|---|---|---|---|---|---|---|---|
| | Type | Part | Type | Part | Type | Part | Type | Part |
| 1 | A-1 | 100 | D-1/D-2 | 6/1 | E-1 | 0.5 | F-1/F-2 | 1420/30 |
| 2 | A-2 | 100 | D-1/D-2 | 6/1 | E-1 | 0.5 | F-1/F-2 | 1420/30 |
| 3 | A-3 | 100 | D-1/D-2 | 6/1 | E-1 | 0.5 | F-1/F-2 | 1420/30 |
| 4 | A-4 | 100 | D-1/D-2 | 6/1 | E-1 | 0.5 | F-1/F-2 | 1420/30 |
| 5 | A-6 | 100 | D-1/D-2 | 6/1 | E-1 | 0.5 | F-1/F-2 | 1420/30 |
| 6 | A-7 | 100 | D-1/D-2 | 6/1 | E-1 | 0.5 | F-1/F-2 | 1420/30 |
| 7 | A-8 | 100 | D-1/D-2 | 6/1 | E-1 | 0.5 | F-1/F-2 | 1420/30 |
| 8 | A-1 | 100 | D-1/D-2 | 6/1 | E-2 | 3 | F-1/F-2 | 1420/30 |
| 9 | A-2 | 100 | D-1/D-3 | 6/1 | E-1 | 0.5 | F-1/F-2 | 1420/30 |
| 10 | A-2 | 100 | D-1/D-4 | 6/1 | E-1 | 0.5 | F-1/F-2 | 1420/30 |

**TABLE 2**

| Second resist agent | Polymer | | Acid generator | | Acid diffusion controller | | Solvent | |
|---|---|---|---|---|---|---|---|---|
| | Type | Part | Type | Part | Type | Part | Type | Part |
| 11 | A-5 | 100 | D-1 | 7 | E-2 | 2 | F-1/F-2 | 1420/30 |
| 12 | A-5 | 100 | D-2 | 7 | E-3 | 3 | F-1/F-2 | 1420/30 |
| 13 | A-5 | 100 | D-2 | 7 | E-1/E-2 | 0.2/1 | F-1/F-2 | 1420/30 |
| 14 | A-5 | 100 | D-2 | 7 | E-1 | 0.5 | F-1/F-2 | 1420/30 |
| 15 | A-2 | 100 | D-2 | 7 | E-2 | 3 | F-1/F-2 | 1420/30 |

### <Acid generator (D)>

(D-1): 4-nonafluoro-n-butylsulfonyloxyphenyl-diphenylsulfonium nonafluoro-n-butanesulfonate
(D-2): triphenylsulfonium·nonafluoro-n-butanesulfonate
(D-3): triphenylsulfonium 2-bicyclo[2.2.1]hept-2-yl-1,1,2,2-tetrafluoroethanesulfonate
(D-4): triphenylsulfonium 2-bicyclo[2.2.1]heptan-2-yl-1,1-difluoroethanesulfonate

### <Acid diffusion controller (E)>

(E-1): (R)-(+)-1-(t-butoxycarbonyl)-2-pyrrolidinemethanol
N-t-butoxycarbonylpyrrolidine
(E-2): triphenylsulfonium salicylate
(E-3): triphenylsulfonium 10-camphorsulfonate

### <Solvent (F)>

(F-1): Propylene glycol monoethyl ether acetate
(F-2): γ-butyrolactone

### (Synthetic Example 9: Polymer (B-1))

92 g of p-hydroxyphenylmethacrylanilide, 46 g of t-butoxystyrene, 13 g of hydroxybutyl acrylate, and 12.8 g azobisisobutyronitrile were dissolved in 600 g of isopropanol, and reacted under refluxing conditions (82°C) for six hours to polymerize the monomers. After cooling the reaction vessel with flowing water, 150 g of isopropanol (IPA) was added. The mixture was poured into 4500 g of methanol while stirring to precipitate the product, followed by suction filtration. The reprecipitation operation (IPA addition through suction filtration) was repeated four times and the resulting product was dried at 50°C to obtain 121 g of Polymer (B-1) having the repeating unit shown by the following formula (B-1) with a monomer molar ratio of p-hydroxyphenyl methacrylanilide/t-butoxystyrene/hydroxybutyl acrylate = 58/32/10 (mol ratio), having an Mw of 5400 and Mw/Mn of 1.6 (yield: 81 %).

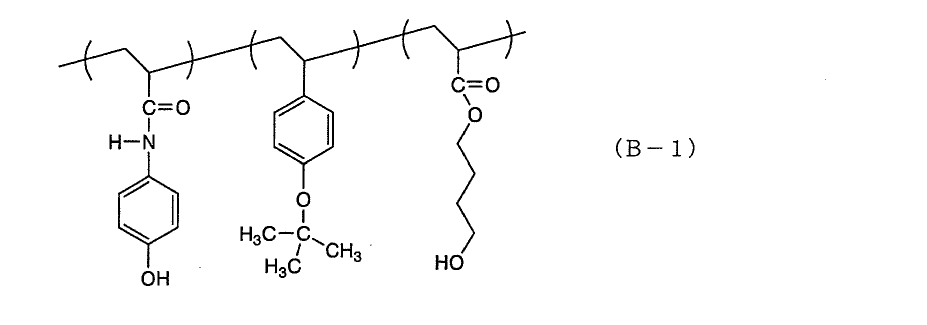

### (Synthetic Example 10: Polymer (B-2))

The experiment was carried out in the same manner as in Synthetic Example 9, except for using p-hydroxymethacrylanilide and p-t-butoxystyrene as starting materials to obtain 110 g of Polymer (B-2) having the repeating unit shown by the following formula (B-2) with a monomer molar ratio of p-hydroxymethacrylanilide (x)/p-t-butoxystyrene (y) = 60/40 (mol ratio), having an Mw of 5500 and Mw/Mn of 1.5 (yield: 75%).

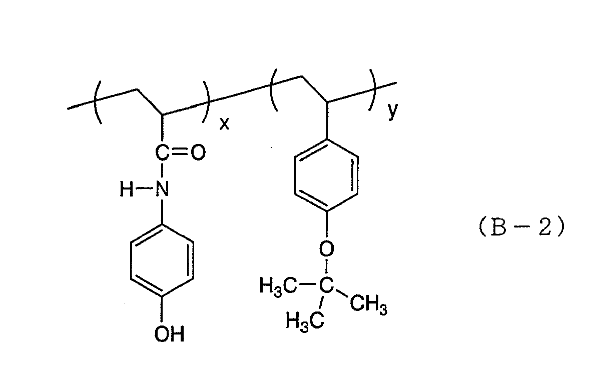

### (Synthetic Example 11: Polymer (B-3))

17.21 g of p-hydroxymethacrylanilide, 8.56 g of t-butoxystyrene, 4.23 g of 2-(((trifluoromethyl)sulfonyl)amino)ethyl-1-methacrylate, and 2.13 g of azobisisobutyronitrile were dissolved in 90 g of isopropanol, and reacted under refluxing conditions (82°C) for six hours to polymerize the monomers. After cooling the reaction vessel with flowing water, 900 g of methanol was added while stirring to precipitate the product, followed by suction filtration. The reprecipitation operation (IPA addition through suction filtration) was repeated four times and the resulting product was dried at 50°C under vacuum to obtain 26 g of Polymer (B-3) having the repeating unit shown by the following formula (B) with a monomer molar ratio of p-hydroxymethacrylanilide (x)/p-t-butoxystyrene (y)/2-(((trifluoromethyl)sulfonyl)amino)ethyl-1-methacrylate (z) = 61/29/10 (mol ratio), having an Mw of 5800 and Mw/Mn of 1.6 (yield: 87%).

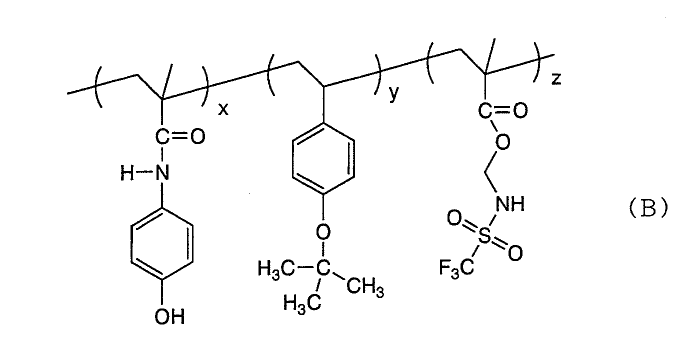

### (Synthetic Example 12: Polymer (B-4))

The experiment was carried out in the same manner as in Synthetic Example 11, except for changing the proportion of the starting materials to obtain 24 g of Polymer (B-4) having the repeating unit shown by the above formula (B) with a monomer molar ratio of p-hydroxymethacrylanilide (x)/t-butoxystyrene (y)/2-(((trifluoromethyl)sulfonyl)amino)ethyl-1-methacrylate (z) = 61/34/5 (mol ratio), having an Mw of 5200 and Mw/Mn of 1.5 (yield: 80%).

### (Synthetic Example 13: Polymer (B-5))

The experiment was carried out in the same manner as in Synthetic Example 11, except for changing the proportion of the starting materials to obtain 27 g of Polymer (B-5) having the repeating unit shown by the above formula (B) with a monomer molar ratio of p-hydroxymethacrylanilide (x)/t-butoxystyrene (y)/2-(((trifluoromethyl)sulfonyl)amino)ethyl-1-methacrylate (z) = 52/38/10 (mol ratio), having an Mw of 5500 and Mw/Mn of 1.5 (yield: 90%).

### (Examples 1 to 11: Preparation insolubilizing resin composition)

Insolubilizing resin compositions (A) to (K) (Examples 1 to 11) were prepared from the Polymers (B-1) to (B-5) by adding the crosslinking agents (C) and the solvents (F) shown in Table 3 in proportions shown in Table 3, stirring the mixture for three hours, and filtering through a filter with a pore diameter of 0.03 µm.

**TABLE 3**

| | Insolubilizing resin composition | Polymer | | Crosslinking agent | | | | Solvent | |
|---|---|---|---|---|---|---|---|---|---|
| | | Type | Part | Type | Part | Type | Part | Type | Part |
| Example 1 | A | B-1 | 100 | C-1 | 30 | - | - | F-3 | 2620 |
| Example 2 | B | B-2 | 100 | C-2 | 30 | - | - | F-3 | 2620 |
| Example 3 | C | B-2 | 100 | C-1 | 30 | - | - | F-3 | 2620 |
| Example 4 | D | B-3 | 100 | C-1 | 30 | - | - | F-3 | 2620 |
| Example 5 | E | B-4 | 100 | C-1 | 30 | - | - | F-3 | 2620 |
| Example 6 | F | B-5 | 100 | C-1 | 30 | - | - | F-3 | 2620 |
| Example 7 | G | B-2 | 100 | C-1 | 20 | - | - | F-3 | 2620 |
| Example 8 | H | B-2 | 100 | C-3 | 20 | - | - | F-3 | 2620 |
| Example 9 | I | B-2 | 100 | C-3 | 10 | C-1 | 10 | F-3 | 2620 |
| Example 10 | J | B-2 | 100 | C-4 | 30 | - | - | F-3 | 2620 |
| Example 11 | K | B-2 | 100 | C-4 | 10 | C-1 | 10 | F-3 | 2620 |

### <Crosslinking component (C)>

C-1: "Nikalac MX-750" (manufactured by Nippon Carbide Industries Co., Inc.)
C-2: Dipentaerythritol hexakis(3-ethyl-3-oxetanylmethyl) ether
C-3: "OXT-121" (manufactured by Toagosei Co., Ltd.)
C-4: "OXPT" (manufactured by Ube Industries)

### <Solvent (F)>

F-3: 1-butanol

### (Reference Example 1)

A coated film with a thickness of 77 nm was formed on a 12 inch silicon wafer by spin coating a lower layer antireflection film ("ARC29A" manufactured by Brewer Science) using "CLEAN TRACK ACT12" (manufactured by Tokyo Electron Ltd.) and baking (PB, 205°C, 60 seconds). The first resist agent (1) was coated using "CLEAN TRACK ACT12", baked (PB, 115°C, 60 seconds), and cooled (23°C, 30 seconds) to obtain a coated film with a thickness of 150 nm. Next, the film was exposed to radiation using an ArF liquid immersion lithographic apparatus ("XT1250i" manufactured by ASML) under the optical conditions of NA: 0.85 and outer/inner = 0.89/0.59 annular through a mask with a mask size of 50 nm line/200 nm pitch. After PEB (115°C for 60 seconds) on a hot plate of "CLEAN TRACK ACT12" and cooling (23°C, 30 seconds), the exposed resist was developed by paddle development (30 seconds) using a developing cup LD nozzle and 2.38 mass% TMAH aqueous solution, and washed with ultra pure water. An evaluation substrate A on which a first resist pattern was formed was obtained by centrifugal drying at 2000 rpm for 15 seconds.

The insolubilizing resin composition (C) was spin coated using "CLEAN TRACK ACT12" on the Evaluation substrate A to a film thickness of 150 nm and baked (PB, 150°C, 60 seconds). After cooling on a cooling plate at 23°C for 30 seconds using "CLEAN TRACK ACT12", the resist was developed by paddle development (60 seconds) using a developing cup LD nozzle and 2.38 mass% TMAH aqueous solution, and washed with ultra pure water. An evaluation substrate B on which an insolubilized resist pattern was formed was obtained by centrifugal drying at 2000 rpm for 15 seconds.

### (Reference Examples 2 to 25)

The evaluation substrates B on which an insolubilized resist pattern was formed were prepared in the same manner as in Reference Example 1 except for using the first resist agents and the insolubilizing resin compositions shown in Tables 4 and 5 under the film forming conditions shown in Tables 4 and 5.

**TABLE4**

| | First resist agent | PB | | PEB | |
|---|---|---|---|---|---|
| | | Temperature (°C) | Time (s) | Temperature (°C) | Time (s) |
| Reference Example 1 | 1 | 115 | 60 | 115 | 60 |
| Reference Example 2 | 2 | 120 | 60 | 115 | 60 |
| Reference Example 3 | 3 | 120 | 60 | 130 | 60 |
| Reference Example 4 | 4 | 100 | 60 | 110 | 60 |
| Reference Example 5 | 5 | 115 | 60 | 110 | 60 |
| Reference Example 6 | 6 | 115 | 90 | 105 | 90 |
| Reference Example 7 | 7 | 115 | 60 | 110 | 60 |
| Reference Example 8 | 8 | 115 | 60 | 110 | 60 |
| Reference Example 9 | 9 | 130 | 60 | 110 | 60 |
| Reference Example 10 | 10 | 130 | 60 | 110 | 60 |
| Reference Example 11 | 2 | 120 | 60 | 115 | 60 |
| Reference Example 12 | 2 | 120 | 60 | 115 | 60 |
| Reference Example 13 | 2 | 120 | 60 | 115 | 60 |
| Reference Example 14 | 2 | 120 | 60 | 115 | 60 |
| Reference Example 15 | 2 | 120 | 60 | 115 | 60 |
| Reference Example 16 | 2 | 120 | 60 | 115 | 60 |
| Reference Example 17 | 2 | 120 | 60 | 115 | 60 |
| Reference Example 18 | 2 | 120 | 60 | 115 | 60 |
| Reference Example 19 | 2 | 120 | 60 | 115 | 60 |
| Reference Example 20 | 2 | 120 | 60 | 115 | 60 |
| Reference Example 21 | 2 | 120 | 60 | 115 | 60 |
| Reference Example 22 | 2 | 120 | 60 | 115 | 60 |
| Reference Example 23 | 2 | 120 | 60 | 115 | 60 |
| Reference Example 24 | 2 | 120 | 60 | 115 | 60 |
| Reference Example 25 | 2 | 120 | 60 | 115 | 60 |

**TABLE 5**

| | Insolubilizing resin composition | PB or UV cure before development | | PB or UV cure after development | | Pattern evaluation |
|---|---|---|---|---|---|---|
| | | Temp (°C) or UV lamp (wavelength) | Time (s) | Temp (°C) or UV lamp (wavelength) | Time (s) | |
| Reference Example 1 | C | 150 | 60 | - | | Good |
| Reference Example 2 | C | 150 | 60 | - | | Good |
| Reference Example 3 | C | 150 | 60 | - | | Good |
| Reference Example 4 | C | 150 | 60 | - | | Good |
| Reference Example 5 | C | 150 | 60 | - | - | Good |
| Reference Example 6 | C | 150 | 60 | - | - | Good |
| Reference Example 7 | C | 150 | 60 | - | - | Good |
| Reference Example 8 | A | 150 | 60 | - | - | Good |
| Reference Example 9 | B | 150 | 60 | - | - | Good |
| Reference Example 10 | C | 150 | 60 | - | - | Good |
| Reference Example 11 | D | 155 | 90 | - | - | Good |
| Reference Example 12 | E | 155 | 90 | - | - | Good |
| Reference Example 13 | F | 155 | 90 | - | - | Good |
| Reference Example 14 | G | 130 | 90 | 165 | 90 | Good |
| Reference Example 15 | H | 130 | 90 | 165 | 90 | Good |
| Reference Example 18 | I | 130 | 90 | 165 | 90 | Good |
| Reference Example 19 | J | 130 | 90 | 165 | 90 | Good |
| Reference Example 20 | K | 130 | 90 | 165 | 90 | Good |
| Reference Example 21 | G | Xe₂ (172 nm) | 60 | - | - | Good |
| Reference Example 22 | G | 130 | 90 | Xe₂ (172 nm) | 60 | Good |
| Reference Example 23 | H | 130 | 90 | 165 | 90 | Good |
| Reference Example 24 | I | 130 | 90 | 165 | 90 | Good |
| Reference Example 25 | K | 130 | 90 | 165 | 90 | Good |

### (Example 12)

The second resist agent (11) was spin coated onto the insolubilized resist pattern of the evaluation substrate B obtained in the Reference Example 1 using "CLEAN TRACK ACT12", baked (PB, 130°C, 60 seconds), and cooled (23°C, 30 seconds) to obtain a coated film with a thickness of 150 nm. The space regions of the insolubilizing resist pattern was exposed to radiation using an ArF liquid immersion lithographic apparatus under the optical conditions of NA: 0.85 and outer/inner = 0.89/0.59 annular through a mask with a mask size of 50 nm line/200 nm pitch. After PEB (95°C for 60 seconds) on a hot plate of "CLEAN TRACK ACT12" and cooling (23°C, 30 seconds), the exposed resist was developed by paddle development (30 seconds) using a developing cup LD nozzle and 2.38 mass% TMAH aqueous solution, and washed with ultra pure water. An evaluation substrate C on which a second resist pattern was formed was obtained by centrifugal drying at 2000 rpm for 15 seconds.

### (Examples 13 to 34)

The evaluation substrates C on which the second resist pattern was formed were prepared in the same manner as in Example 12 except for using the evaluation substrates B obtained in Reference Examples 2 to 25 and the second resist agents shown in Table 7 under the film forming conditions shown in Table 7.

### (Comparative Examples 1 to 3)

The evaluation substrates C were prepared in the same manner as in Example 12 except that the evaluation substrates A were used without processing with the insolubilizing resin composition and the second resist pattern was prepared on the first resist pattern under the conditions shown in Table 7.

### (Pattern evaluation)

Resist patterns formed on the evaluation substrates A to C were evaluated using a scanning electron microscope ("S-9380" manufactured by Hitachi High-Tech Fielding Corporation) according to the following standard.

### <Evaluation substrate A>

Formation or non-formation of 50 nm line/200 nm pitch resist patterns (130 nm line/240 nm pitch resist patterns in Reference Examples 23 to 25) was confirmed.

### <Evaluation substrate B>

Formation or non-formation of 50 nm line/200 nm pitch resist patterns (130 nm line/240 nm pitch resist patterns in Reference Examples 23 to 25) was confirmed. The results were evaluated as "Good" if the first resist pattern remained and as "Bad" if the first resist pattern has disappeared. The evaluation results are shown in Table 5.

### <Evaluation substrate C>

The results were evaluated as "Good" if an additional line-and-space pattern with a 50 nm line/200 nm pitch (50 nm 1L/1S) (a contact hole pattern with a 90 nm hole/240 nm pitch in Examples 32 to 34) was formed. The results were evaluated as "Bad" if (i) the first resist pattern has disappeared and (ii) the second resist pattern was not formed or if (iii) the first resist pattern remained without being dissolved even if the second resist pattern was formed. The evaluation results are shown in Table 7.

**TABLE 6**

| | Fist layer | PB | | PEB | | Insolubilizing resin composition | PB or UV cure before development | | PB or UV cure after development | |
|---|---|---|---|---|---|---|---|---|---|---|
| | First resist agent | Temp (°C) | Time (s) | Temp (°C) | Time (s) | | Temp (°C) or UV lamp (wavelength) | Time (s) | Temp (°C) or UV lamp (wavelength) | Time (s) |
| Example 12 | 1 | 115 | 60 | 115 | 60 | C | 150 | 60 | - | - |
| Example 13 | 2 | 120 | 60 | 115 | 60 | C | 150 | 60 | - | - |
| Example 14 | 3 | 120 | 60 | 130 | 60 | C | 150 | 60 | - | - |
| Example 15 | 4 | 100 | 60 | 110 | 60 | C | 150 | 60 | - | - |
| Example 16 | 5 | 115 | 60 | 110 | 60 | C | 150 | 60 | - | - |
| Example 17 | 6 | 115 | 90 | 105 | 90 | C | 150 | 60 | - | - |
| Example 18 | 7 | 115 | 60 | 110 | 60 | C | 150 | 60 | - | - |
| Example 19 | 8 | 115 | 60 | 110 | 60 | A | 150 | 60 | - | - |
| Example 20 | 9 | 130 | 60 | 110 | 60 | B | 150 | 60 | - | - |
| Example 21 | 10 | 130 | 60 | 110 | 60 | C | 150 | 60 | - | - |
| Example 22 | 2 | 120 | 60 | 115 | 60 | D | 155 | 90 | - | - |
| Example 23 | 2 | 120 | 60 | 115 | 60 | E | 155 | 90 | - | - |
| Example 24 | 2 | 120 | 60 | 115 | 60 | F | 155 | 90 | - | - |
| Example 25 | 2 | 120 | 60 | 115 | 60 | G | 130 | 90 | 165 | 90 |
| Example 26 | 2 | 120 | 60 | 115 | 60 | H | 130 | 90 | 165 | 90 |
| Example 27 | 2 | 120 | 60 | 115 | 60 | I | 130 | 90 | 165 | 90 |
| Example 28 | 2 | 120 | 60 | 115 | 60 | J | 130 | 90 | 165 | 90 |
| Example 29 | 2 | 120 | 60 | 115 | 60 | K | 130 | 90 | 165 | 90 |
| Example 30 | 2 | 120 | 60 | 115 | 60 | G | Xe₂ (172 nm) | 60 | - | - |
| Example 31 | 2 | 120 | 60 | 115 | 60 | G | 130 | 90 | Xe₂ (172 nm) | 60 |
| Example 32 | 2 | 120 | 60 | 115 | 60 | H | 130 | 90 | 165 | 90 |
| Example 33 | 2 | 120 | 60 | 115 | 60 | I | 130 | 90 | 165 | 90 |
| Example 34 | 2 | 120 | 60 | 115 | 60 | K | 130 | 90 | 165 | 90 |
| Comparative Example 1 | 1 | 120 | 60 | 115 | 60 | - | - | - | - | - |
| Comparative Example 2 | 2 | 120 | 60 | 115 | 60 | - | - | - | - | - |
| Comparative Example 3 | 3 | 120 | 60 | 115 | 60 | - | - | - | - | - |

**TABLE 7**

| | Second layer | | PB | | PEB | | Pattern evaluation |
|---|---|---|---|---|---|---|---|
| | First resist agent | Second resist agent | Temp (°C) | Time (s) | Temp (°C) | Time (s) | |
| Example 12 | - | 11 | 130 | 60 | 95 | 60 | Good |
| Example 13 | - | 12 | 130 | 60 | 95 | 60 | Good |
| Example 14 | - | 13 | 130 | 60 | 95 | 60 | Good |
| Example 15 | - | 14 | 130 | 60 | 95 | 60 | Good |
| Example 16 | - | 15 | 130 | 60 | 95 | 60 | Good |
| Example 17 | - | 11 | 130 | 60 | 95 | 60 | Good |
| Example 18 | - | 11 | 130 | 60 | 95 | 60 | Good |
| Example 19 | - | 11 | 130 | 60 | 95 | 60 | Good |
| Example 20 | - | 11 | 130 | 60 | 95 | 60 | Good |
| Example 21 | - | 11 | 130 | 60 | 95 | 60 | Good |
| Example 22 | - | 12 | 100 | 60 | 95 | 60 | Good |
| Example 23 | - | 12 | 100 | 60 | 95 | 60 | Good |
| Example 24 | - | 12 | 100 | 60 | 95 | 60 | Good |
| Example 25 | - | 12 | 100 | 60 | 95 | 60 | Good |
| Example 26 | - | 12 | 100 | 60 | 95 | 60 | Good |
| Example 27 | - | 12 | 100 | 60 | 95 | 60 | Good |
| Example 28 | - | 12 | 100 | 60 | 95 | 60 | Good |
| Example 29 | - | 12 | 100 | 60 | 95 | 60 | Good |
| Example 30 | - | 12 | 100 | 60 | 95 | 60 | Good |
| Example 31 | - | 12 | 100 | 60 | 95 | 60 | Good |
| Example 32 | - | 12 | 100 | 60 | 95 | 60 | Good (holes) |
| Example 33 | - | 12 | 100 | 60 | 95 | 60 | Good (holes) |
| Example 34 | - | 12 | 100 | 60 | 95 | 60 | Good (holes) |
| Comparative Example 1 | 1 | - | 130 | 60 | 95 | 60 | Bad |
| Comparative Example 2 | - | 11 | 130 | 60 | 95 | 60 | Bad |
| Comparative Example 3 | - | 12 | 130 | 60 | 95 | 60 | Bad |

### INDUSTRIAL APPLICABILITY

According to the resist pattern formation method of the present invention, a resist pattern space can be effectually and accurately miniaturized and excellent patterns surpassing the wavelength limit can be economically formed. For this reason, the resist pattern formation method of the present invention is extremely suitable in the field of microfabrication represented by manufacturing of semiconductor devices, which will become more and more minute.

## Claims

1. A resist pattern formation method comprising:
(1) a step of forming a first resist pattern which comprises forming a first resist layer on a substrate using a first positive-tone radiation-sensitive resin composition, selectively exposing the first resist layer to radiation through a mask, and developing the exposed resist,
(2) a step of insolubilizing the first resist pattern in a developer and a second positive-tone radiation-sensitive resin composition by coating the first resist pattern with a resist pattern insolubilizing resin composition which comprises a resin having a hydroxyl group and an alcohol solvent, baking the resist pattern insolubilizing resin composition or curing the resist pattern insolubilizing resin composition with UV, and developing the resist pattern insolubilizing resin composition,
(3) a step of forming a second resist layer on the insolubilized resist pattern using the second positive-tone radiation-sensitive resin composition and selectively exposing the second resist layer to radiation through a mask, and
(4) a step of developing the exposed second resist layer to form a second resist pattern.

2. The resist pattern formation method according to claim 1,
wherein the insolubilized resist pattern and the second resist pattern are respectively line-and-space patterns each having line parts and space parts, and the line parts of the second resist pattern are formed on the space parts of the insolubilized resist pattern.

3. The resist pattern formation method according to claim 2,
wherein the line parts of the second resist pattern are formed on the space parts of the insolubilized resist pattern in parallel to the line parts of the insolubilized resist pattern.

4. The resist pattern formation method according to claim 2,
wherein the line parts of the second resist pattern are formed on the space parts of the insolubilized resist pattern to form a contact hole pattern possessing contact holes which are partitioned by the line parts of the insolubilized resist pattern and the line parts of the second resist pattern.

5. The resist pattern formation method according to claim 1,
wherein the insolubilized resist pattern and the second resist pattern are respectively line-and-space patterns each having line parts and space parts and the method further comprises forming the line parts of the second resist pattern on the line parts of the insolubilized resist pattern so as to cause the line parts of the second resist pattern to cross the line parts of the insolubilized resist pattern.

6. The resist pattern formation method according to claim 1,
wherein at least one of the first positive-tone radiation-sensitive resin composition and the second positive-tone radiation-sensitive resin composition comprises a resin having a repeating unit shown by the following general formula (1), 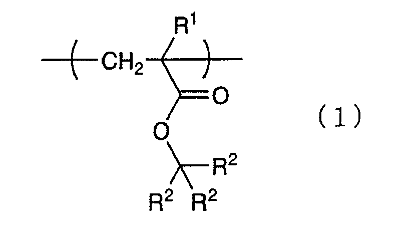 wherein R¹ represents a hydrogen atom or a methyl group and R²s individually represent a monovalent alicyclic hydrocarbon group having 4 to 20 carbon atoms, a derivative thereof, or a linear or branched alkyl group having 1 to 4 carbon atoms, or (i) at least one of the R²s represents a monovalent alicyclic hydrocarbon group having 4 to 20 carbon atoms or a derivative thereof, or (ii) any two of the R²s bond with each other to form a divalent alicyclic hydrocarbon group having 4 to 20 carbon atoms including the carbon atom to which the R²s bond, or a derivative thereof, with the remaining R² being a linear or branched alkyl group having 1 to 4 carbon atoms, a monovalent alicyclic hydrocarbon group having 4 to 20 carbon atoms, or a derivative thereof.

7. A resist pattern insolubilizing resin composition used in the step (2) of the resist pattern formation method according to any one of claims 1 to 6, comprising:
a resin having a hydroxyl group and an alcohol solvent and capable of insolubilizing the first resist pattern in a developer and the second positive-tone radiation-sensitive resin composition.

8. The resist pattern insolubilizing resin composition according to claim 7,
wherein the alcohol solvent is a nonaqueous solvent which contains an alcohol or an alcohol-containing solvent having a water content of 10 mass% or less.

9. The resist pattern insolubilizing resin composition according to claim 8, wherein the alcohol solvent is a monohydric alcohol having 1 to 8 carbon atoms.

10. The resist pattern insolubilizing resin composition according to claim 7,
further comprising a crosslinking component.

11. The resist pattern insolubilizing resin composition according to claim 10,
wherein the crosslinking component is at least one of a compound having a group shown by the following general formula (2) and a compound having two or more cyclic ether reactive groups, 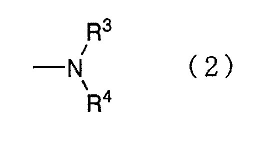 wherein R³ and R⁴ individually represent a hydrogen atom or a group shown by the following general formula (3), provided that at least one of R³ and R⁴ represents a group shown by the following general formula (3), 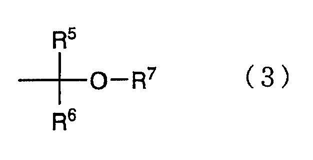 wherein R⁵ and R⁶ individually represent a hydrogen atom, an alkyl group having 1 to 6 carbon atoms, an alkoxyalkyl group having 1 to 6 carbon atoms, or R⁵ and R⁶ bond together to form a ring having 2 to 10 carbon atoms, and R⁷ represents a hydrogen atom or an alkyl group having 1 to 6 carbon atoms.

12. The resist pattern insolubilizing resin composition according to claim 7,
wherein the resin having a hydroxyl group is obtained by polymerizing a monomer component which contains either hydroxyacrylanilide or hydroxymethacrylanilide.

13. The resist pattern insolubilizing resin composition according to claim 12,
wherein the resin having a hydroxyl group comprises a repeating unit shown by the following general formula (4), 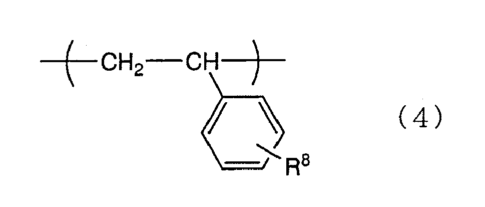 wherein R⁸ represents a hydrogen atom, a linear or branched alkyl group having 1 to 8 carbon atoms, or a linear or branched alkoxy group having 1 to 8 carbon atoms.

14. The resist pattern insolubilizing resin composition according to claim 7,
wherein the second positive-tone radiation-sensitive resin composition contains at least one of an iodonium salt compound and a sulfonium salt compound which can generate a base by decomposing upon exposure to radiation.
